# EUROPEAN PATENT APPLICATION

(11) **EP 2 818 882 A1**
(43) Date of publication of application: **31.12.2014**
(21) Application number: 13760379.1
(22) Date of filing: 28.02.2013
(51) Int. Cl.: G01R 31/26, H01L 31/04

(54) **SOLAR CELL MODULE MANUFACTURING METHOD, SOLAR CELL OUTPUT MEASUREMENT METHOD, AND SOLAR CELL OUTPUT MEASUREMENT JIG**

(30) Priority: 16.03.2012 JP 2012060609; 16.03.2012 JP 2012060610
(71) Applicant: Dexerials Corporation, Tokyo 141-0032 (JP)
(72) Inventor: MORI, Daichi, Kanuma-shi, Tochigi 322-8503 (JP)
(74) Representative: Hill, Christopher Michael
(86) International application number: PCT/JP2013/055344
(87) International publication number: WO 2013/136999

(57) **Abstract**

A method for producing a solar battery module, which contains: arranging tab wire on an electrode of a solar cell via an adhesive; connecting the tab wire with a measuring device for measuring electrical characteristics of the solar cell, to measure electrical characteristics of the solar cell; judging a grade of the solar cell based on a result of the measurement; and modularizing the solar cells of the same grade.

## Description

### Technical Field

The present invention relates to a method for producing a solar battery module, and particularly relates to a method for producing a solar battery module, in a production process of which a grade of a solar cell element is judged, and a string is formed according to the grade of the solar cell elements. Moreover, the present invention relates to an output measuring device configured to measure electrical characteristics of a solar cell, and particularly relates to an improvement of an electrode terminal in contact with the solar cell.

### Background Art

As for a measuring device for measuring electrical characteristics of a solar cell, conventionally typically used is a measuring device equipped with a plurality of probe pins in contact with bus bar electrode of a solar cell (for example, see PTL 1). This type of the measuring device has a probe pin for measuring electric current, which is configured to measure electric current passed in a solar cell, and a probe pin for measuring voltage, which is configured to measure voltage generated in the solar cell.

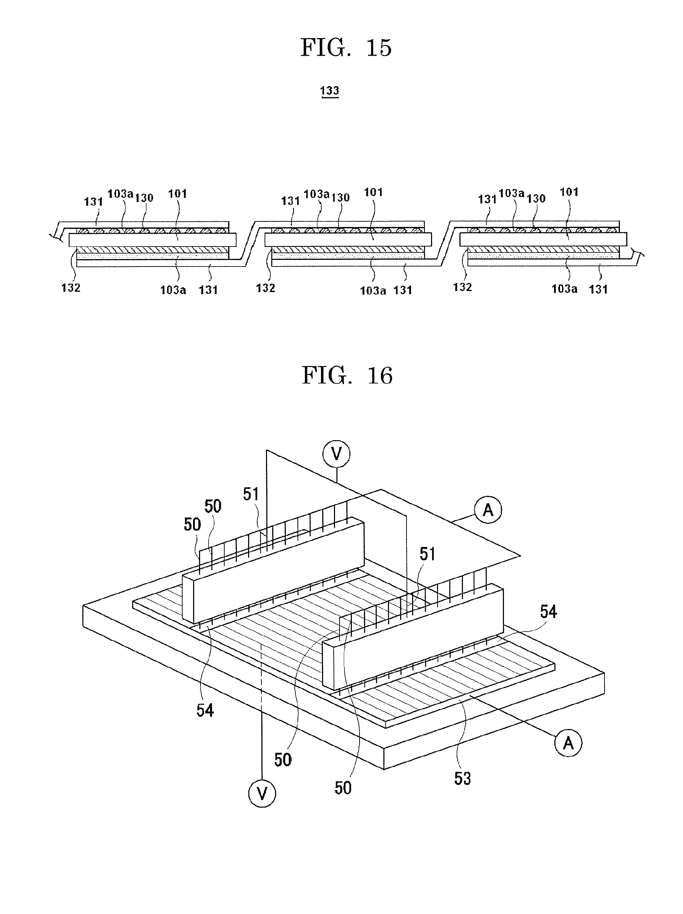

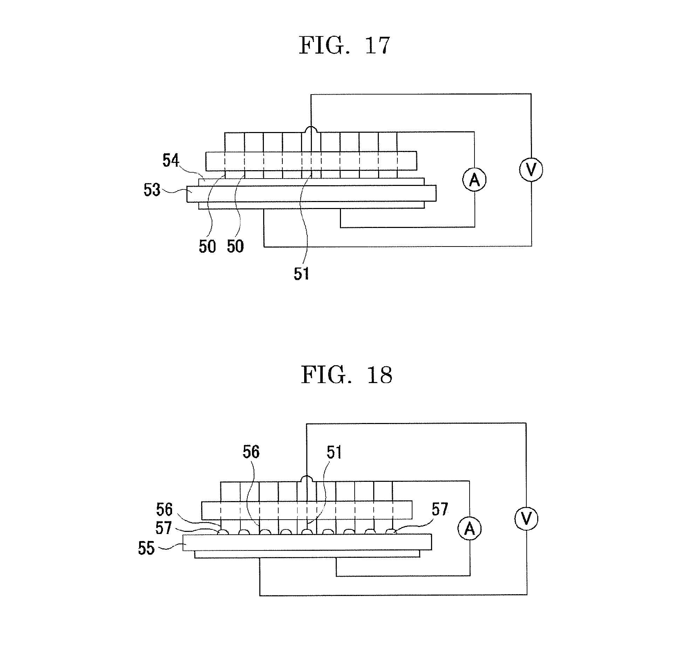

As illustrated in FIGs. 16 and 17, for example, a measurement of electrical characteristics of a solar cell is performed by a so-called four-terminal sensing, in which a probe pin 50 for measuring electric current and a probe pin 51 for measuring voltage are placed on and brought into contact with a bus bar electrode 54 of a solar cell 53, the electric current passed in the solar cell 53 and the voltage generated in the solar cell 53 are generated while applying simulated solar light to a light-accepting surface of the solar cell 53.

Recently, proposed is a method where tab wire, which will be a direct interconnector, is connected via an electrically conductive adhesive film to be perpendicular to finger electrodes, without providing bus bar electrodes, in order to reduce a production const by reducing an amount of electrode materials for use, such as an Ag paste, as well as reducing a number of production steps of a solar cell. Even such a solar cell having a bus bar-less structure has the power collection efficiency equal to or greater than that of a solar cell, in which bus bar electrodes are formed.

When a measurement of electrical characteristics is performed on a solar cell 55 having a bus bar-less structure, it is necessary to bring a probe pin 56 directly into contact with a finger electrode 57. As illustrated in FIG. 18, however, an interval with which probe pins 56 are provided may not often match an interval with which finger electrodes 57 are formed. In this case, all of the finger electrodes 57 cannot be conducted and there are some finger electrodes 57 that are outside a target of the measurement. Therefore, accurate electrical characteristics cannot be measured.

In order to solve such a problem, proposed is a measurement method where a rectangular plate-shaped bar electrode is used as a measuring terminal, and is provided on a light-accepting surface of a solar cell to cross over all the finger electrodes, without using probe pins (for example, see PTL 2).

In the measuring method using the bar electrode, it is necessary to contact a contacting surface of the bar electrode with each finger electrode. However, it is difficult to form the bar electrode to accurately achieve flatness of the contacting surface of the bar electrode, or is difficult to adjust levelness relative to a solar cell. In the case where heights of the finger electrodes are not even in the plane of the solar cell, moreover, it is difficult to bring the bar electrode with all of the finger electrodes with sufficient pressure.

When simulated sun light is applied at the time of output measurement of a solar cell, a shadow of a measuring device is formed on a light-accepting surface to cause a shadow loss, and therefore it is difficult to achieve an accurate output measurement. Moreover, it is complicated to correct a measured value by calculating the shadow loss caused by the measuring device. Furthermore, a device, which can measure a solar cell having a bus bar-less structure is expensive, and a measuring step is complicated in terms of alignment of a probe pin with a finger electrode, or adjustment of contact pressure. Therefore, it is desired to provide a method for measuring output of a solar cell, which can easily measure output of a solar cell in a production process of a solar battery module.

Moreover, solar cells, to which a measurement of output characteristics has been performed, are classified into grades according to the output characteristics. For example, grading is carried out to separate solar cells for a high quality solar battery module, which have excellent output characteristics, from solar cells for a standard solar battery module, which have output characteristics that satisfy the predetermined specification but are not excellent.

Thereafter, the solar cells are aligned by a grade, and are reciprocally connected with tab wire to form a string. If a measurement of output characteristics of a solar cell and formation of a solar cell string are smoothly interlocked, efficiency of a production process of a solar battery module improves. Therefore, such smooth interlocked processes are desirable.

### Citation List

### Patent Literature

PTL1: Japanese Patent Application Laid-Open (JP-A) No. 2006-118983
PTL2: JP-A No. 2010-177379

### Summary of Invention

### Technical Problem

The present invention aims to solve the aforementioned various problems in the art and achieve the following object. Specifically, an object of the present invention is to provide a method for producing a solar battery module, which can efficiently produce a solar battery module by interlocking a measurement of output characteristics of a solar cell, and modularization of the solar cells, a method for measuring output of a solar cell, which can easily and accurately measure electrical characteristics of various solar cells, such as a bus bar-less structure solar cell, not only a solar cell equipped with a bus bar electrode, and a device for measuring output of a solar cell.

### Solution to Problem

The means for solving the aforementioned problems are as follows:
<1> A method for producing a solar battery module, containing:
   arranging tab wire on an electrode of a solar cell via an adhesive;
   connecting the tab wire with a measuring device for measuring electrical characteristics of the solar cell, to measure electrical characteristics of the solar cell;
   judging a grade of the solar cell based on a result of the measurement; and
   modularizing the solar cells of the same grade.
<2> The method for producing a solar battery module according to <1>, wherein the modularizing contains sealing the solar cells with a sealing material and a protective material, and connecting the tab wire piercing through the sealing material and the protective material with a terminal box.
<3> The method for producing a solar battery module according to <1>, wherein the modularizing contains aligning the solar cells of the same grade, and forming a string with the tab wire.
<4> The method for producing a solar battery module according to any one of <1> to <3>, wherein the arranging contains forming the adhesive into a film, and laminating the adhesive on a surface of the tab wire, which is brought into in contact with the solar cell.
<5> The method for producing a solar battery module according to any one of <1>, <2> and <4>, wherein the solar cell is a thin film solar cell.
<6> The method for producing a solar battery module according to any one of <1>, <3> and <4>, wherein the solar cell is a crystal silicon solar cell, and has a bus bar-less structure.
<7> A method for measuring output of a solar cell, containing:
   arranging a measuring terminal piece formed of a ribbon-formed metal foil on an electrode of a solar cell via an adhesive; and
   connecting an ampere meter or a volt meter, or both with the measuring terminal piece, to measure electrical characteristics of the solar cell.
<8> The method for measuring output of a solar cell according to <7>, wherein the measuring terminal piece has a length equal to or longer than a length of the electrode formed over a space between two sides of the solar cell facing to each other.
<9> The method for measuring output of a solar cell according to <7> or <8>, wherein the arranging contains forming the adhesive into a film, and laminating the adhesive on a surface of the measuring terminal piece, which is brought into in contact with the solar cell.
<10> The method for measuring output of a solar cell according to any one of <7> to <9>, wherein the adhesive is releasable from the solar cell after the connecting.
<11> The method for measuring output of a solar cell according to any one of <7> to <10>, wherein a tacking force of the adhesive is 0.1 N or greater but less than 5 N.
<12> The method for measuring output of a solar cell according to any one of <7> to <11>, wherein the adhesive is an electrically conductive adhesive, in which electrically conductive filler is dispersed in a binder resin.
<13> The method for measuring output of a solar cell according to <12>, wherein an amount of the electrically conductive filler in the adhesive is 5 parts by mass to 60 parts by mass, relative to 80 parts by mass of the binder resin.
<14> The method for measuring output of a solar cell according to <12>, wherein an amount of the electrically conductive filler in the adhesive is 20 parts by mass to 40 parts by mass, relative to 80 parts by mass of the binder resin.
<15> The method for measuring output of a solar cell according to any one of <7> to <14>, wherein a surface roughness (Rz) of the metal foil is 5 µm to 20 µm.
<16> The method for measuring output of a solar cell according to any one of <7> to <15>, wherein the solar cell is a crystal solar cell and has a bus bar-less structure.
<17> The method for measuring output of a solar cell according to any one of <7> to <15>, wherein the solar cell is a thin film solar cell.
<18> A device for measuring output of a solar cell, containing:
   a measuring terminal piece, which is connected to an ampere meter or a voltmeter, or both, and is formed of a ribbon-formed metal foil that is arranged on an electrode of a solar cell via an adhesive,
   wherein the device is configured to measure electrical characteristics of the solar cell.
<19> The device for measuring output of a solar cell according to <18>, wherein the measuring terminal piece has a length equal to or greater than a length of the electrode formed over a space between two sides of the solar cell facing to each other.

### Advantageous Effects of the Invention

The present invention can solve the aforementioned various problems in the art, and can provide a method for producing a solar battery module, which can efficiently produce a solar battery module by interlocking a measurement of output characteristics of a solar cell, and modularization of the solar cells, a method for measuring output of a solar cell, which can easily and accurately measure electrical characteristics of various solar cells, such as a bus bar-less structure solar cell, not only a solar cell equipped with a bus bar electrode, and a device for measuring output of a solar cell.

### Brief Description of Drawings

FIG. 1A is a perspective view illustrating a production process of a thin film solar battery module according to the present invention, and illustrates that a laminate is bonded.
FIG. 1B is a plan view illustrating a production process of a thin film solar battery module according to the present invention.
FIG. 2 is a perspective view of a thin film solar battery module according to the present invention.
FIG. 3 is a cross-sectional view illustrating a laminate of tab wire and an adhesive layer.
FIG. 4 is a plan view of a thin film solar battery module.
FIG. 5 is a process drawing depicting a production process of a thin film solar battery module according to the present invention.
FIG. 6 is a perspective view of a silicon solar battery module according to the present invention.
FIG. 7A is a perspective view illustrating a measuring step of output characteristics of a silicon solar cell element.
FIG. 7B is a cross-sectional view illustrating a measuring step of output characteristics of a silicon solar cell element.
FIG. 8 is a cross-sectional view illustrating a strong of silicon solar cell elements.
FIG. 9A is a perspective view illustrating a step for measuring output characteristics of a thin film solar cell.
FIG. 9B is a plan view illustrating a step for measuring output characteristics of a thin film solar cell.
FIG. 10A is a perspective view illustrating a step for measuring output characteristics of a crystal silicon solar cell.
FIG. 10B is a plan view illustrating a step for measuring output characteristics of a crystal silicon solar cell.
FIG. 11 is a cross-sectional view illustrating an electrically conductive adhesive film.
FIG. 12 is a cross-sectional view illustrating a laminate of a measuring terminal piece and an electrically conductive adhesive film.
FIG. 13A is a perspective view illustrating a modularizing step of thin film solar cells, and illustrating a step for connecting tab wire.
FIG. 13B is a modularizing step of thin film solar cells, and illustrating a solar cell connected with tab wire.
FIG. 14 is a perspective view illustrating a thin film solar battery module.
FIG. 15 is a cross-sectional view illustrating a crystal silicon solar cell string.
FIG. 16 is a perspective view illustrating a state where electrical characteristics of a solar cell is measured by means of a conventional measuring device using a probe pin.
FIG. 17 is a diagram for explaining a measurement performed by means of a conventional measuring device using a probe pin.
FIG. 18 is a diagram for explaining a measurement of electrical characteristics of a solar cell having a bus bar-less structure by means of a conventional measuring device using a probe pin.

### Description of Embodiments

The method for producing a solar battery, method for measuring output of a solar cell, and a device for measuring output according to the present invention are specifically explained with reference to drawings hereinafter. Note that, the drawings are schematic illustration, and a proportion of each size therein may be different from an actual proportion. A specific size should be judged based on the descriptions below. Moreover, there are of course parts where a relationship or ratio of sizes is different between drawings.

### (Method for Producing Solar Battery Module)

The method for producing a solar battery module of the present invention contains at least an arranging step, a measuring step, a judging step, and a modularizing step, and may further contain other steps, as necessary.

The arranging step is appropriately selected depending on the intended purpose without any limitation, provided that it is a step containing arranging tab wire on an electrode of a solar cell via an adhesive.

The measuring step is appropriately selected depending on the intended purpose without any limitation, provided that it is a step containing the tab wire to a measuring device configured to measure electrical characteristics of the solar cell to measure the electrical characteristics of the solar cell.

The judging step is appropriately selected depending on the intended purpose without any limitation, provided that it is a step containing judging a grade (rating) of the solar cell based on the measurement result of the measuring step.

The modularizing step is appropriately selected depending on the intended purpose without any limitation, provided that it is a step containing modularizing the solar cells of the same grade.

The modularizing step preferably contains sealing the solar cell with a sealing material and a protective material, and connecting the tab wire piercing the sealing material and the protective material with a terminal box.

The modularizing step preferably contains aligning the solar cells of the same grade to form a string with the tab wire.

The arranging step preferably contains forming the adhesive into a film, and laminating the adhesive on a surface of the tab wire, which is brought into contact with the solar cell.

The solar cell is preferably a thin film solar cell.

The solar cell is preferably a crystal silicon solar cell, and preferably has a bus bar-less structure.

### [Thin Film Solar Battery Module]

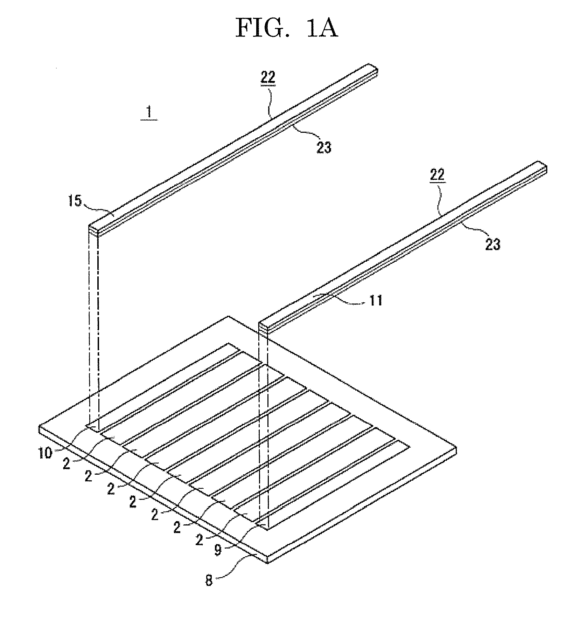

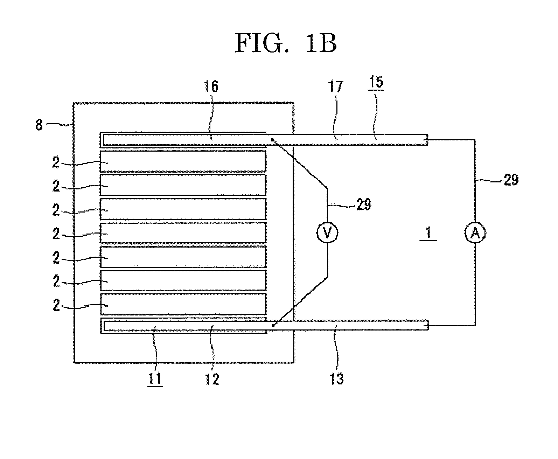

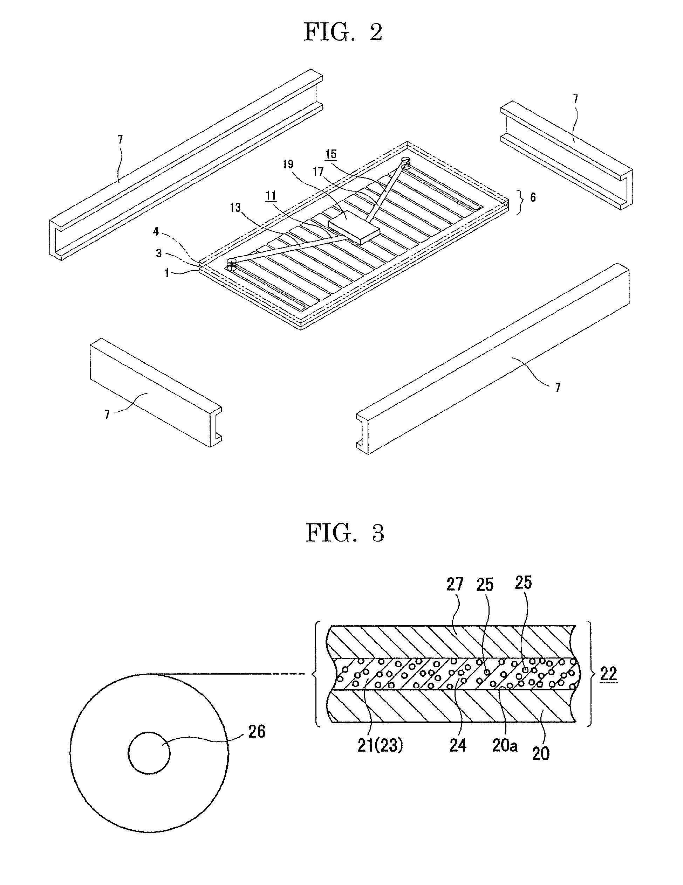

As for a solar cell constituting a solar battery module, for example, a so-called thin film solar cell 1, in which a semiconductor layer serving as a photoelectric conversion layer is formed on a substrate, such as glass, and stainless steel, can be used. As illustrated in FIGs. 1A and 1B, the thin film solar cell 1 constitutes a solar cell string, in which a plurality of solar cell elements 2 is connected with a contact line. As illustrated in FIG. 2, the thin film solar cell 1 having this string structure alone, or a matrix constituted by linking a plurality thereof are collectively laminated with a sealing adhesive sheet 3 and a back sheet 4 provided at the rear face thereof, to thereby form a thin film solar battery module 6. Note that, a metal frame 7, such as aluminum, is appropriately provided to the periphery of the thin film solar battery module 6.

As for the sealing adhesive, for example, a translucent sealing material, such as an ethylene vinyl acetate resin (EVA) is used. As for the back sheet 4, moreover, a plastic film or sheet having excellent properties, such as weather resistance, thermal resistance, water resistance, and light fastness, is used. As for the back sheet 4, for example, a laminate sheet having a structure of polyvinyl fluoride (PVF)/polyethylene terephthalate (PET)/polyvinyl fluoride (PVF), which utilizes characteristics of a fluorine-based resin, such as high resistance, can be used.

### [Solar Cell Element]

The thin film solar cell 1 according to the present invention is formed by laminating a transparent electrode film, a photoelectric conversion layer, and a rear face electrode film in this order on a translucent insulating substrate 8, though they are omitted in the drawings. The thin film solar cell 1 is a super straight-type solar cell, to which light enters from the side of the translucent insulating substrate 8. Note that, as for the thin film solar cell, there is also a substraight-type solar cell, in which a base, a rear face electrode, a photoelectric conversion layer, and a transparent electrode are formed in this order. An example of the super straight-type thin film solar cell 1 is explained hereinafter, but the present invention can be also used for a substraight-type thin film solar cell.

As for the solar cell to which the present invention is applied, moreover, a general thin film solar cell (for example, various thin film solar cells, such as amorphous silicon thin film solar cell, a microcrystal tandem thin film solar cell, a CdTe thin film solar cell, a CIS thin film solar cell, and a flexible thin film solar cell), or a silicon solar cell, such as a single crystal silicon solar cell, a polysilicon solar cell, and a HIT solar cell, can be used.

As for the translucent insulating substrate 8, glass, or a heat resistant resin, such as polyimide, can be used.

As for the transparent electrode film, for example, SnO₂, ZnO, ITO, IZO, or AZO (a transparent electrode body, in which zinc oxide is doped with Al) can be used.

As for the photoelectric conversion layer, for example, a silicon-based photoelectric conversion film, such as amorphous silicon, microcrystal silicon, and polycrystal silicon, or a compound-based photoelectric conversion film, such as CdTe, CuInSe₂, and Cu(In,Ga)Se₂ can be used.

For example, the rear face electrode film has a laminate structure containing a transparent electrically conductive film, and a metal film. As for the transparent electrode film, for example, SnO₂, ZnO, ITO, IZO, or AZO can be used. As for the metal film, for example, silver or aluminum can be used.

In the thin film solar cell 1 constituted in the aforementioned manner, as illustrated in 1A, a plurality of rectangular solar cell elements 2 each having a length that is equal to substantially the entire width of the translucent insulating substrate 8 is formed. Each solar cell element 2 is divided with an electrode dividing line, and a transparent electrode film of one solar cell element 2 and a rear face electrode film of another adjacent solar cell element 2 are connected with a contact line, to thereby constitute a solar cell string, in which a plurality of the solar cell elements 2 is connected in series.

Then, in the thin film solar cell 1, a linear p-type electrode terminal part 9, which has the substantially same length to that of the solar cell element 2, is formed on an edge of a transparent electrode film of the solar cell element 2, which is provided at one end of the solar cell string, and a linear n-type electrode terminal part 10, which has the substantially same length to that of the solar cell element 2, is formed on an edge of a rear face electrode film of a solar cell element 2, which is provided at the other end of the solar cell string. In the thin film solar cell 1, these p-type electrode terminal part 9 and n-type electrode terminal part 10 serve as outlets of the electrodes, and supply electricity to a terminal box 19 via the tab wire for a positive electrode 11 and the tab wire for a negative electrode 15.

As well as the tab wire for a positive electrode 11 and the tab wire for a negative electrode 15 extract electricity by conductively connecting with the p-type electrode terminal part 9 and n-type electrode terminal part 10 of a thin film solar cell 1, the tab wire for a positive electrode 11 and the tab wire for a negative electrode 15 become measuring terminals to be connected with an ampere meter A, or a voltmeter V or both at the time of the measurement of electrical characteristics. As illustrated in FIG. 3, the tab wire for a positive electrode 11 and the tab wire for negative electrode 15 are each formed, for example, by laminating an adhesive layer 21 on the entire surface of the tab wire 20 to be integrated.

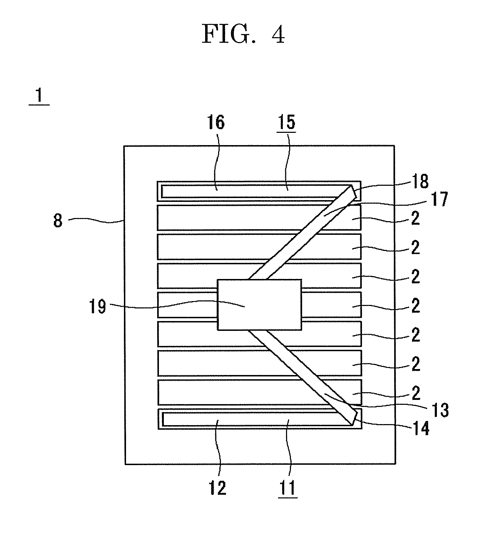

As illustrated in FIG. 4, the tab wire for a positive electrode 11 contains a positive electrode power collection tab part 12, and a positive electrode connection tab part 13. The positive power collection tab part 12 is connected onto the p-type electrode terminal part 9 of the thin film solar cell 1 via the adhesive layer 21. The positive electrode connection tab part 13 is connected with a terminal box 19, as well as being connected to an ampere meter A, or a voltmeter V, or both. The positive electrode power collection tab part 12 and the positive electrode connection tab part 13 are continued to each other via a turning part 14. Note that, in FIG. 4, a sheet 3 of a sealing adhesive material and a back sheet 4 are not illustrated, as a matter of practical convenience.

At the time of a measurement of electrical characteristics of the thin film solar cell 1, the positive electrode connection tab part 13 is connected with an ampere meter A, or a voltmeter V, or both. At the time of modularization of a thin film solar cell 1, the positive electrode connection tab part 13 pierces through the sheet 3 of a sealing adhesive material and the back sheet 4, and is connected with a terminal box 19 provided on the back sheet 4.

The tab wire for a negative electrode 15 contains a negative electrode power collection tab part 16, and a negative electrode connection tab part 17. The negative electrode power collection tab part 16 is connected onto the n-type electrode terminal part 10 of the thin film solar cell 1 via the adhesive layer 21. The negative electrode connection tab part 17 is connected to the terminal box 19, as well as being connected to an ampere meter A, a voltmeter V, or both. The negative electrode power collection tab part 16 and the negative electrode connection tab part 17 are continued to each other via a turning part 18.

At the time of a measurement of electrical characteristics of the thin film solar cell 1, the negative electrode connection tab part 17 is connected to an ampere meter A, or a voltmeter V, or both. At the time of modularization of a thin film solar cell 1, the negative electrode connection tab part 17 pierces through the sheet 3 of a sealing adhesive material and the back sheet 4, and is connected to the terminal box 19 provided on the back sheet 4.

The tab wire for a positive electrode 11 is specifically explained hereinafter. The tab wire for a negative electrode 15 has the same structure to that of the tab wire for a positive electrode 11.

The tab wire 20 is , for example, a rectangular wire having a width of 1 mm to 3 mm, which is substantially the same width to that of the p-type electrode terminal part 9. The tab wire 20 is formed, for example, by slitting a copper foil or aluminum foil, which has been rolled to give the average thickness of 9 µm to 300 µm, or rolling a thin metal wire, such as copper, and aluminum, into a rectangular shape.

The positive electrode power collection tab part 12 has a length substantially equal to that of the p-type electrode terminal part 9, and is electrically and mechanically jointed to the entire surface of the p-type electrode terminal part 9 via the adhesive layer 21 laminated on one surface of the tab wire 20. Moreover, the positive electrode connection tab part 13 is a connection part of the tab wire for a positive electrode 11 partially turned by the turning part 14. At the time of a measurement of electrical characteristics of the thin film solar cell 1, the positive electrode connection part 13 serves as a measuring terminal that is connected to an ampere meter A, or a voltmeter V, or both. At the time of modularization, thereafter, the positive electrode connection part 13 pierces through insertion holes provided in the sheet 3 of a sealing adhesive material and the back sheet 4, and is turned on the back sheet 4, and the edge thereof is connected to a terminal block of the terminal box 19 provided on the back sheet 4.

The turning part 14 is provided at part of the tab wire for a positive electrode 11, for example, at the edge of the positive electrode power collection tab part 12. the part of the tab wire for a positive electrode 11, which extends from the turning part 14, becomes the positive electrode connection tab part 13. In the tab wire for a positive electrode 11, the positive electrode power collection tab part 12 and the positive electrode connection tab part 13 are continued to each other via the turning part 14, and thus the tab wire for a positive electrode 11 does not have a joint part. Therefore, an increase in resistance or reduction in connection reliability at a joint part due to concentration of electric charge in the joint part, and damage on the translucent insulating substrate 8 caused by concentration of heat or stress in the joint part can be prevented.

The tab wire for a positive electrode 11 preferably has a length substantially twice the length of the p-type electrode terminal part 9, and is preferably turned at a position which is about 50% in the entire length thereof. As a result of this, the tab wire for a positive electrode 11 enables to securely connect the positive electrode connection tab part 13 with the terminal boxy 19 regardless of a position of the terminal box 19 on the back sheet 4 of the thin film solar cell 1. The tab wire for negative electrode 15 is also the same.

As illustrated in FIG. 3, in the tab wire for a positive electrode 11 and the tab wire for a negative electrode 15, an adhesive layer 21 configured to connect the p-type electrode terminal part 9 or n-type electrode terminal part 10 with a surface 20a of the tab wire 20 is provided. The adhesive layer 21 is provided on the entire surface 20a of the tab wire 20, and is composed, for example, of coating solder, or an electrically conductive adhesive film 23.

As illustrated in FIG. 3, the electrically conductive adhesive film 23 contains electrically conductive particles 25 in a heat-curing binder resin layer 24 at a high density. In view of compression properties, moreover, the electrically conductive adhesive film 23 contains the binder resin, the minimum melt viscosity of which is preferably 100 Pa·s to 100,000 Pa·s. When the minimum melt viscosity is too low, the resin of the electrically conductive adhesive film 23 may be flown out during curing, because of low pressure bonding, and therefore connection failures or bleeding of the resin onto a surface of a cell tends to occur. When the minimum melt viscosity is too high, failures tend to occur at the time of film bonding, which may adversely affect connection reliability. Note that, the minimum melt viscosity can be measured by loading the predetermined amount of a sample in a rotational viscometer, and carrying out the measurement with increasing the temperature at the predetermined heating rate.

The electrically conductive particles 25 for use in the electrically conductive adhesive film 23 are not particularly limited, and examples thereof include: metal particles, such as nickel, gold, silver, and copper; gold-plated resin particles; and gold-plated resin particles outermost surfaces of which is coated with an insulating material.

The electrically conductive particles may be powder, in which particles are individually present, but are preferably chained particles, in which primary particles are linked. Examples of the former particles include spherical nickel powder, in which each particle has spiky protrusions. Examples of the latter particles that are preferably used include filament nickel powder. Use of the latter particles can give elasticity to the electrically conductive particles 25, and can improve connection reliability between the tab wire for a positive electrode 11 and the p-type electrode terminal part 9, which have mutually different physical properties, and connection reliability between the tab wire for a negative electrode 15 and the n-type electrode terminal part 10, which have mutually different physical properties.

Note that, the viscosity of the electrically conductive adhesive film 23 is preferably 10 kPa·s to 10,000 kPa·s at around room temperature, more preferably 10 kPa·s to 5,000 kPa·s. When the viscosity of the electrically conductive adhesive film 23 is within the range of 10 kPa·s to 10,000 kPa·s, so-called blocking caused by spreading can be prevented and the predetermined tacking force can be maintained in the case where the electrically conductive adhesive film 23 is provided on a surface 20a of the tab wire 20, and is wound around a reel 26.

A composition of the binder resin layer 24 of the electrically conductive adhesive film 23 is not particularly limited, as long as it does not adversely affect the aforementioned characteristics. The composition more preferably contains a film forming resin, a liquid epoxy resin, a latent curing agent, and a silane coupling agent.

The film forming resin is a high molecular weight resin having the number average molecular weight of 10,000 or greater. In view of film formability, the number average molecular weight of the film forming resin is preferably about 10,000 to about 80,000. As for the film forming resin, various resins, such as an epoxy resin, a modified epoxy resin, a urethane resin, and a phenoxy resin, can be used. Among them, a phenoxy resin is suitably used in view of a state of film formation, and connection reliability.

As for the liquid epoxy resin, any of commercial epoxy resins can be used without any limitation, as long as the epoxy resin for use has fluidity at room temperature. Specific examples of the epoxy resin include a naphthalene-based epoxy resin, a biphenyl-based epoxy resin, a phenol novolak-based epoxy resin, a bisphenol-based epoxy resin, a stilbene-based epoxy resin, a triphenol methane-based epoxy resin, a phenol aralkyl-based epoxy resin, a naphthol-based epoxy resin, a dicyclopethadiene-based epoxy resin, and a triphenylmethane-based epoxy resin. These may be used alone, or in combination. Moreover, the epoxy resin may be used in combination with appropriately selected another organic resin, such as an acrylic resin.

As for the latent curing agent, various curing agents, such as a heat curing agent, and a UV curing agent, can be used. The latent curing agent does not initiate a reaction in a normal state, but the latent curing agent is activated by some sort of a trigger to initiate a reaction.

The trigger includes heat, light, and pressure, and can be selected depending on the intended use. Among them, a heat-curing latent curing agent is preferably used in the present embodiment, and the binder resin layer is cured, as heated and pressed by the p-type electrode terminal part 9, and the n-type electrode terminal part 10. In the case where the liquid epoxy resin is used, as for the latent curing agent, a latent curing agent composed of imidazole, amine, sulfonium salt, or onium salt can be used.

As for the silane coupling agent, for example, an epoxy-based silane coupling agent, an amino-based silane coupling agent, a mercapto-sulfide based silane coupling agent, or a ureide-based silane coupling agent can be used. Among them, an epoxy-based silane coupling agent is preferably used in the present embodiment. Use of the silane coupling agent can improve adhesion at the interface between an organic material and an inorganic material.

As for other additives, moreover, inorganic filler is preferably contained. Since the electrically conductive adhesive film 23 contains the inorganic filler, the fluidity of the resin layer is controlled at the time of pressure bonding, to thereby improve a particle capturing rate. As for the inorganic filler, for example, silica, talc, titanium oxide, calcium carbonate, or magnesium oxide can be used. A type of the inorganic filler is not particularly limited.

FIG. 3 is a diagram schematically illustrating a laminate 22, in which the tab wire 20 and the electrically conductive adhesive film 23 are laminated. This electrically conductive adhesive film 23 is laminated on a binder resin layer 24 provided on a release base 27, and is formed into a tape. The tape-formed electrically conductive adhesive film 23 is laminated and wound around a reel 26 so that the release base 27 is present at the circumferential side. The release base 27 is not particularly limited. As for the release base 27, for example, polyethylene terephthalate (PET), oriented polypropylene (OPP), poly-4-methylpentene-1 (PMP), or polytetrafluoroethylene (PTFE) can be used.

The electrically conductive adhesive film 23 is laminated on a surface 20a of the tab wire 20 of the tab wire for a positive electrode 11 or tab wire for a negative electrode 15. As the tab wire 20 and the electrically conductive adhesive film 23 are laminated and integrated in advance, upon usage, the tab wire for a positive electrode 11 or the tab wire for a negative electrode 15 is temporarily bonded to the electrode terminal part 9, 10 by removing the release base 27, and bonding the binder resin layer 24 of the electrically conductive adhesive film 23 to the p-type electrode terminal part 9 or the n-type electrode terminal part 10.

In order to obtain the aforementioned electrically conductive adhesive film 23, first, a resin generating solution is obtained by dissolving the electrically conductive particles 25, the film forming resin, the liquid epoxy resin, the latent curing agent, and the silane coupling agent in a solvent. As for the solvent, for example, toluene, ethyl acetate, or a mixed solvent thereof can be used. The resin generating solution obtained by dissolving is applied on the release base 27, and the solvent is evaporated, to thereby obtain an electrically conductive adhesive film 23. Thereafter, the electrically conductive adhesive film 23 is bonded onto a surface 20a of the tab wire 20. As a result, a laminate 22, in which the electrically conductive adhesive film 23 is provided on the entire surface 20a of the tab wire 20, is obtained.

The tab wire for a positive electrode 11 or tab wire for a negative electrode 15, to which such the electrically conductive adhesive film 23 has been formed, is temporarily bonded on the p-type electrode terminal part 9 or n-type electrode terminal part 10, followed by heated and pressed by means of a heat press head or vacuum laminator at the predetermined temperature and pressure. As a result, the binder resin of the electrically conductive adhesive film 23 is flown between the p-type electrode terminal part 9 and the positive electrode power collection tab part 12, and between the n-type electrode terminal part 10 and the negative electrode power collection tab part 16, as well as sandwiching the electrically conductive particles 25 between each of the power collection tab parts 12, 16 and each of the electrode terminal parts 9, 10. In this state, the binder resin is cured. As a result, the electrically conductive adhesive film 23 bonds the power collection tab parts 12, 16 onto the electrode terminal parts 9, 10, respectively, and at the same time, the power collection tab parts 12, 16 are respectively conductively connected to the electrode terminal parts 9, 10.

Note that, as for the adhesive layer 21 configured to connect the p-type electrode terminal part 9 with the tab wire for a positive electrode 11 or connect the n-type electrode terminal part 10 with the tab wire for a negative electrode 15, other than the aforementioned electrically conductive adhesive film 23, an insulating adhesive film can be used.

The insulating adhesive film has the same structure to that of the electrically conductive adhesive film, provided that the binder resin layer does not contain electrically conductive particles.

### (Method for Measuring Output of Solar Cell)

The method for measuring output of a solar cell according to the present invention contains at least an arranging step, and a measuring step, and may further contain other steps according to the necessity.

The arranging step is appropriately selected depending on the intended purpose without any limitation, provided that it is a step containing arranging a measuring terminal piece formed of a ribbon-formed metal foil onto an electrode via an adhesive.

The measuring step is appropriately selected depending on the intended purpose without any limitation, provided that it is a step containing connecting an ampere meter or a volt meter, or both with the measuring terminal piece, to measure electrical characteristics of the solar cell.

The measuring terminal piece preferably has a length equal to or greater than a length of the electrode formed over a space between two sides of the solar cell facing to each other.

The arranging step preferably contains forming the adhesive into a film, and laminating the adhesive on a surface of the tab wire, which is brought into in contact with the solar cell.

The adhesive is preferably releasable from the solar cell after the measuring step.

The tacking force of the adhesive is preferably 0.1 N or greater but less than 5 N.

The adhesive is preferably an electrically conductive adhesive, in which electrically conductive filler is dispersed in a binder resin.

An amount of the electrically conductive filler in the adhesive is appropriately selected depending on the intended purpose without any limitation, but the amount thereof is preferably 5 parts by mass to 60 parts by mass, more preferably 20 parts by mass to 40 parts by mass, relative to 80 parts by mass of the binder resin.

The surface roughness (Rz) of the metal foil is preferably 5 µm to 20 µm.

The solar cell is preferably a crystal solar cell having a bus bar-less structure.

The solar cell is preferably a thin film solar cell.

### (Device for Measuring Output of Solar Cell)

The device for measuring output of a solar cell according to the present invention contains at least a measuring terminal piece, and may further contain other members, as necessary.

The device for measuring output of a solar cell is a device configured to measure electrical characteristics of a solar cell.

The measuring terminal piece is connected with an ampere meter, or a voltmeter, or both, and is arranged on an electrode of the solar cell via an adhesive.

The measuring terminal piece is formed of a ribbon-formed metal foil.

The measuring terminal piece preferably has a length equal to or greater than a length of the electrode formed over a space between two sides of the solar cell facing to each other.

### [Production process of Thin Film Solar Battery Module]

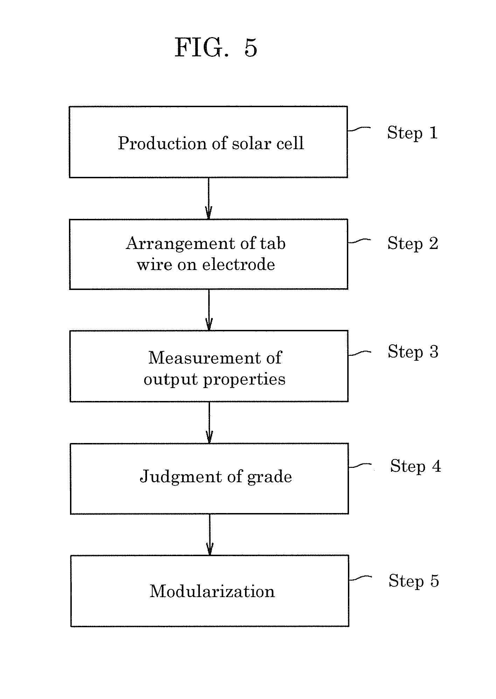

Subsequently, a production process of the aforementioned thin film solar battery module 6 is explained. As illustrated in FIG. 5, the production process of the thin film solar battery module 6 contains: a step containing producing a thin film solar cell 1 (Step 1); a step containing arranging a laminate 22 on the p-type electrode terminal part 9 and n-type electrode terminal part 10 of the thin film solar cell 1 (Step 2); a step containing connecting an ampere meter A, or a voltmeter V, or both to the tab wire 20 of the laminate 22 to measure electrical characteristics (output characteristics) of the thin film solar cell 1 (Step 3); a step containing judging a grade of the thin film solar cell 1 based on the measurement result (output result) (Step 4); and a step containing modularizing thin film solar cells 11 according to the grade (Step 5).

The thin film solar cell 1 is produced by a typical method. Laminates 22 are respectively arranged on a p-type electrode terminal part 9 and n-type electrode terminal part 10 of the thin film solar cell 1 (FIGs. 1A and 1B). The laminates 22 are each pulled out from a reel 26 by the predetermined length, and are cut, followed by removing the release base 27. The exposed electrically conductive adhesive films 23 are respectively arranged on the p-type electrode terminal part 9 and the n-type electrode terminal part 10, and the laminates 22 were pressed for the predetermined period from the side of the tab wire by a bonder. As a result, the tab wire for a positive electrode 11 and the tab wire for a negative electrode 15 (tab wire 20) were respectively provided on the p-type electrode terminal part 9 and the n-type electrode terminal part 10 via the electrically conductive adhesive film 23.

The thin film solar cell 1, to which the tab wire for a positive electrode 11 and the tab wire for a negative electrode 15 are connected, is subjected to a measurement of electrical characteristics (electric power characteristics), and classified with a grade according to the measurement result (output characteristics). For example, grading is carried out to separate thin film solar cells 1 for a high quality solar battery module, which have excellent output characteristics, from thin film solar cells 1 for a standard solar battery module, which have output characteristics that satisfy the predetermined specification but are not excellent.

The measurement of the output characteristics is carried out by connecting an ampere meter A, or a voltmeter V, or both with the connection tab parts 13, 17, which are respectively extended from the power collection tab parts 12, 16 of the tab wire for a positive electrode 11 and tab wire for a negative electrode 15, via a cable 29. The measurement of the electrical characteristics of the thin film solar cell 1 can be carried out by applying the predetermined simulated sun light to a surface of the thin film solar cell 1.

As the connection tab parts 13, 17 of the tab wire for a positive electrode 11 and tab wire for a negative electrode 15 are used as measuring terminals in the measurement, electric power characteristics can be easily measured without using a dedicated measuring device. In the case where a dedicated measuring device is used, it is necessary to consider an influence of a shadow of the device to reduce output. As the connection tab parts 13, 17 are used as measuring terminals, however, it is not necessary to consider the aforementioned influence of a shadow. Note that, it is necessary to consider resistance of the connection tab parts 13, 17, when the connection tab parts 13, 17 are used as measuring terminals. However, the resistance of the tab wire 20 is already known, and a correction of an electric current value and voltage value performed as passing the connection tab parts 13, 17 is easy. On the other hand, a calculation for correcting output reduction due to an influence of a shadow of a measuring device is complicated, and accuracy thereof is also insufficient.

Thereafter, the thin film solar cell 1 is graded according to the output characteristics, such as high quality, and standard quality, and then is moved onto the modularization step depending on the grade. In the modularizing step, the thin film solar cells 1 are aligned by the grade to form a solar cell string via the tab wire for a positive electrode 11 and the tab wire for a negative electrode 15 to form a solar cell string. The solar cell string, or the thin film solar cell 1 alone is modularized A sheet 3 of a sealing adhesive material and a back sheet 4 are laminated on a rear face of the thin film solar cell 1 or the solar cell string, and they are collectively laminated and sealed by a vacuum laminator. At the time of the lamination, the connection tab parts 13,17 pierce through insertion holes provided in the sheet 3 of a sealing adhesive material and the back sheet 4, and are connected to a terminal box 19 provided on the back sheet 4 (FIG. 2).

As described above, a measurement of electric power characteristics, grading and modularization can be continuously performed with the thin film solar cell 1, by using the connection tab parts 13, 17 connected to the terminal box 19 as measuring terminals for electric power characteristics. In accordance with the aforementioned method for producing a solar battery module, therefore, a production process is made efficient without using a dedicated device for measuring output characteristics of a solar cell.

### [Silicon Solar Cell]

Note that, an example where the thin film solar cell 1 is used as a solar cell is explained above, but power collection, measurement, and connection of cells can also similarly be performed using tab wire when a silicon solar cell is used as a solar cell.

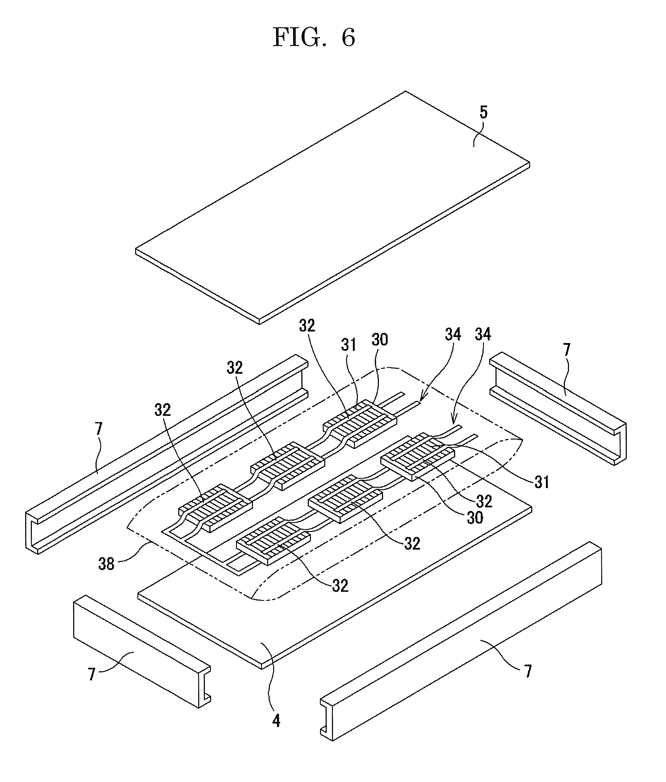

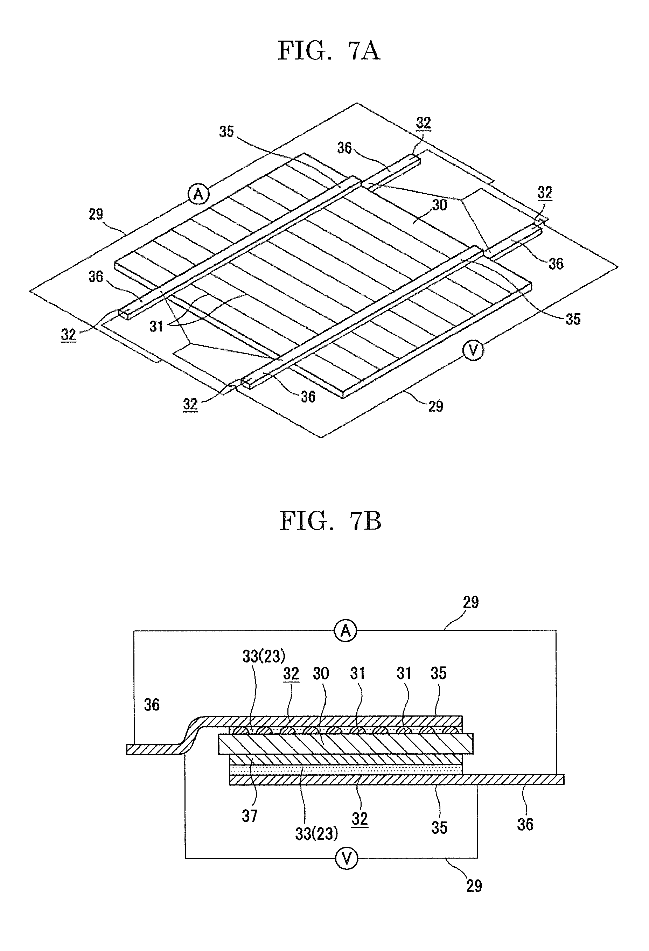

As illustrated in FIGs. 6, 7A and 7B, in a silicon solar cell element 30, in which a plurality of finger electrodes 31 are provided on a light-accepting surface over a space between facing the sides thereof, for example, the tab wire 32 crossing over all the finger electrodes 31 is connected via the adhesive layer 33. Similarly to the aforementioned tab wire for a positive electrode 11 and tab wire for a negative electrode 15, the tab wire 32 is connected to a light-accepting surface of the silicon solar cell element 30, and serves as the power collection tab part 35 configured to connect with the finger electrodes 31 or the rear face electrode 37, and serves as the measuring terminal connected to an ampere meter A, or a voltmeter V, or both at the time of a measurement of electric power characteristics of the silicon solar cell element 30. At the time of the modularization performed thereafter, the tab wire 32 contains a connection tab part 36 connected to an electrode of an adjacent silicon solar cell element 30, or tab wire 32 provided to an adjacent silicon solar cell element 30.

Similarly to the aforementioned adhesive layer 21, an electrically conductive adhesive film 23 or an adhesive paste is used as the adhesive layer 33. Moreover, the electrically conductive adhesive films 23 may be laminated on both surfaces of tab wire 32, and may be collectively bonded to the silicon solar cell element 30. Alternatively, the electrically conductive adhesive film 23 may be formed separately from the tab wire 32, and the electrically conductive adhesive film 23 and the tab wire 32 may be separately bonded to the silicon solar cell element 30.

The power collection tab part 35 has a length substantially equal to one side of the silicon solar cell element 30 perpendicular to the length direction of the finger electrode, and is conductively connected to the finger electrodes 31 with the adhesive layer 33. The connection tab part 36 is a portion extended from the power collection tab part 35, and is conductively connected to finger electrodes 31 or a rear face electrode 37 of an adjacent silicon solar cell element 30, or is conductively connected to a connection tab part 36 of tab wire 32 similarly provided to an adjacent silicon solar cell element 30. As a result, the silicon solar cell elements 30 constitute a string 34. This string 34 is sandwiched with sheets 3 of a sealing adhesive, and are collectively laminated with a surface cover 5 provided at the side of a light-accepting surface, and a back sheet 4 provided at the side of a rear face, to thereby form a silicon solar battery module 38. Note that, a metal frame 7, such as aluminum, is provided at the periphery of the silicon solar battery module 38.

### [Production Process of Silicon Solar Battery Module]

Subsequently, a production process of the aforementioned silicon solar battery module 38 is explained. Similarly to the production process of the thin film solar battery module, the production process of the silicon solar battery module 38 also contains: a step containing producing a silicon solar cell element 30 (Step 1); a step containing arranging tab wires on finger electrodes 31 and a rear face electrode 37 of the silicon solar cell element 30 (Step 2); connecting an ampere meter A, a voltmeter V, or both to the tab wires 32, to measure electrical characteristics of the silicon solar cell element 30 (Step 3); a step containing judging a grade of the silicon solar cell element 30 based on the measurement result (Step 4); and a step containing modularizing silicon solar cell elements 30 according to the grade (Step 5), as illustrated in FIG. 5.

The silicon solar cell element 30 is produced by a typical method. After forming finger electrodes 31 and a rear face electrode of the silicon solar cell element 30, power collection tab parts 35 of tab wires 32 are bonded to the light-accepting surface and the rear face via the adhesive layer 33. Note that, an example of a bus bar-less type silicon solar cell element 30, which does not have a bus bar electrode, is explained hereinafter, but the present invention can also be applied to a silicon solar cell element 30 having bus bar electrodes. As illustrated in FIG. 7A, for example, two tab wires 32 are bonded so that they cross over all the finger electrodes 31 formed on a light-accepting surface. As illustrated in FIG. 7B, moreover, two tab wires 32 are bonded to the predetermined positions of the rear face electrode 37 formed at the rear face.

Thereafter, the silicon solar cell element 30 is subjected to a measurement of electric power characteristics, and is then classified with grades according to the output characteristics. For example, grading is carried out to separate silicon solar cell elements 30 for a high quality solar battery module, which have excellent output characteristics, from silicon solar cell elements 30, which have output characteristics that satisfy the predetermined specification but are not excellent.

As for the measurement of the output characteristics, the electrical characteristics of the silicon solar cell element 30 can be performed by so-called four-terminal sensing, in which an ampere meter A, or a voltmeter V, or both are connected to the connection tab parts 36 which are each extended from the power collection tab part 35 of the tab wire 32, via a cable 29, and the predetermined simulated sun light is applied onto a surface of the silicon solar cell element 30.

As the connection tab part 36 of the tab wire 32 is used as a measuring terminal in the measurement, electric power characteristics can be easily measured without using a dedicated measuring device. In the case where a dedicated measuring device is used, it is necessary to consider an influence of a shadow of the device to reduce output. As the connection tab part 36 is used as a measuring terminal, however, it is not necessary to consider the aforementioned influence of a shadow. Note that, it is necessary to consider resistance of the connection tab part 36, when the connection tab part 36 is used as a measuring terminal. However, the resistance of the tab wire 32 is already known, and a correction of an electric current value and voltage value performed as passing the connection tab part 36 is easy. On the other hand, a calculation for correcting output reduction due to an influence of a shadow of a measuring device is complicated, and accuracy thereof is also insufficient. As the tab wire 32 uses a metal foil, such as a copper foil, as a base, and the tab wire 32 is bonded onto a surface of the silicon solar cell element 30 via the electrically conductive adhesive film 23, moreover, the tab wire 32 can correspond to protrusions of the finger electrodes 31 and uniformly connect with all the finger electrodes 31, and therefore an accurate measurement of output characteristics can be performed.

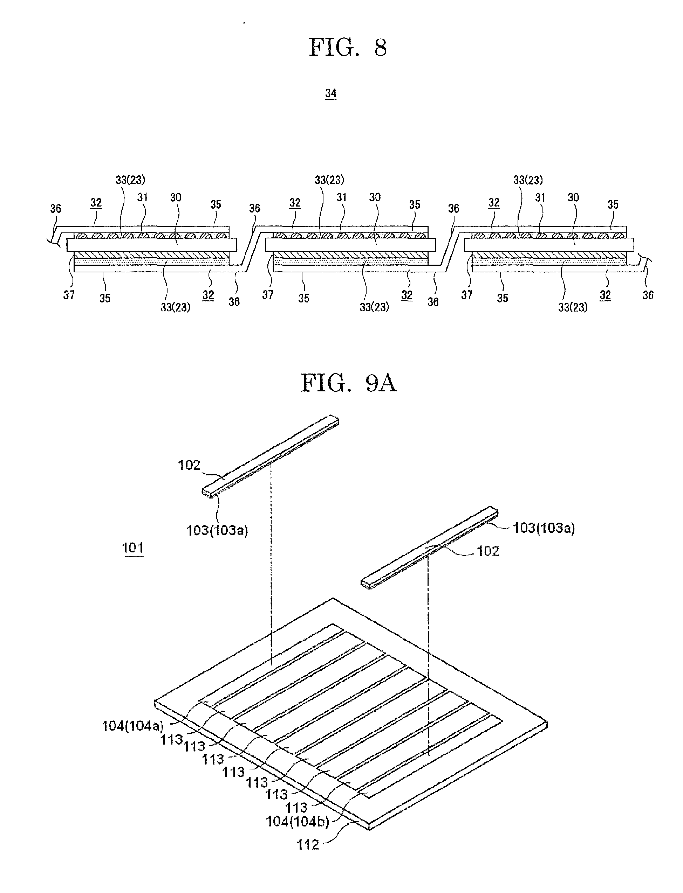

Thereafter, the silicon solar cell element 30 is graded according to the output characteristics, such as high quality, and standard quality, and then is moved onto the modularization step depending on the grade. In the modularizing step, as illustrated in FIG. 8, the connection tab part 36 used as the measuring terminal is, as it is and as an interconnector, connected to a connection tab part 36 of tab wire 32 bonded to an adjacent silicon solar cell element 30, with solder or an adhesive to form a string 34. Alternatively, the connection tab part 36 is connected to the finger electrode 31 and the rear face electrode 37 to form a string 34. The string 34 is composed of silicon solar cell elements 30 of the same grade. As a result, a silicon solar battery module 38 of high quality, or a silicon solar battery module 38 of standard quality can be produced. Subsequently, a sheet 3 of a sealing adhesive material, a surface cover 5, and a back sheet 4 are laminated on a surface and back surface of the string 34, and they are collectively laminated and sealed by a vacuum laminator, to thereby form a silicon solar battery module 38. Note that, a metal frame 7, such as aluminum, is appropriately provided to the periphery of the silicon solar battery module 38 (FIG. 6).

As mentioned above, a measurement of electric power characteristics, grading, and modularization can be continuously carried out on a silicon solar cell, by using the connection tab part 36 to be contacted with an adjacent silicon solar cell element 30 as an electric power characteristics measuring terminal. In accordance with the aforementioned method for producing a solar battery module, therefore, a production process can be made efficient. In accordance with this method, moreover, a defective detected by the grading is not applied to the modularizing step, and thus the productivity can be improved compared to the conventional art.

Note that, in the case where bus bar electrodes crossing finger electrodes 31 are formed on a light-accepting surface, the tab wire 32 is connected to the bus bar electrode via the adhesive layer 33, in the silicon solar cell element. In this case, a process from a measurement of electric power characteristics and modularization can also be efficiently performed without using a dedicated measuring device, by using the connection tab part 36 of the tab wire 32 as a measuring terminal.

### [Method for Measuring Output of Solar Cell]

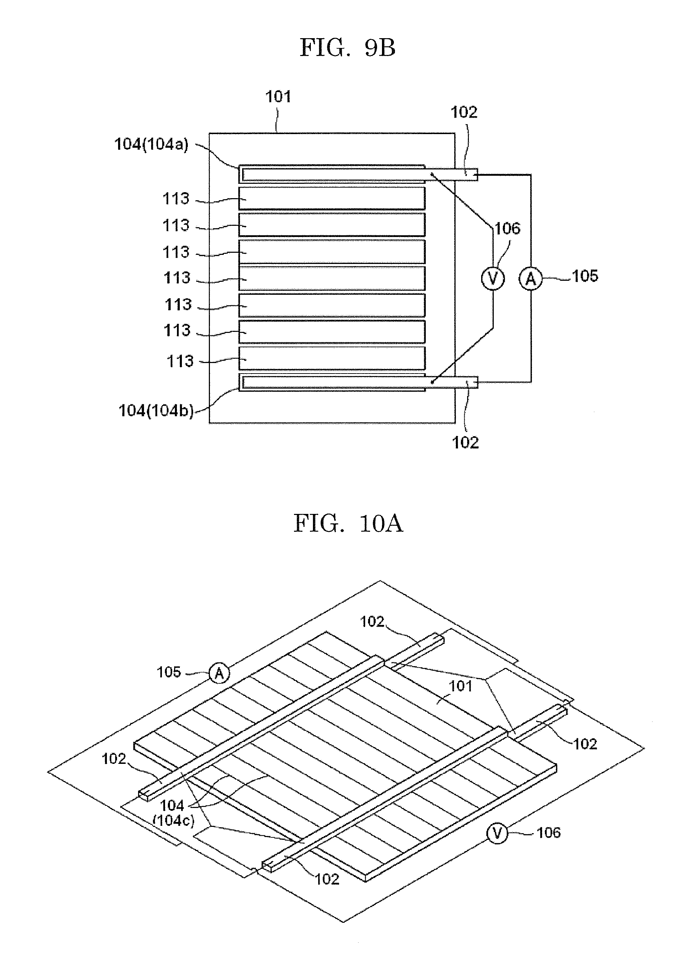

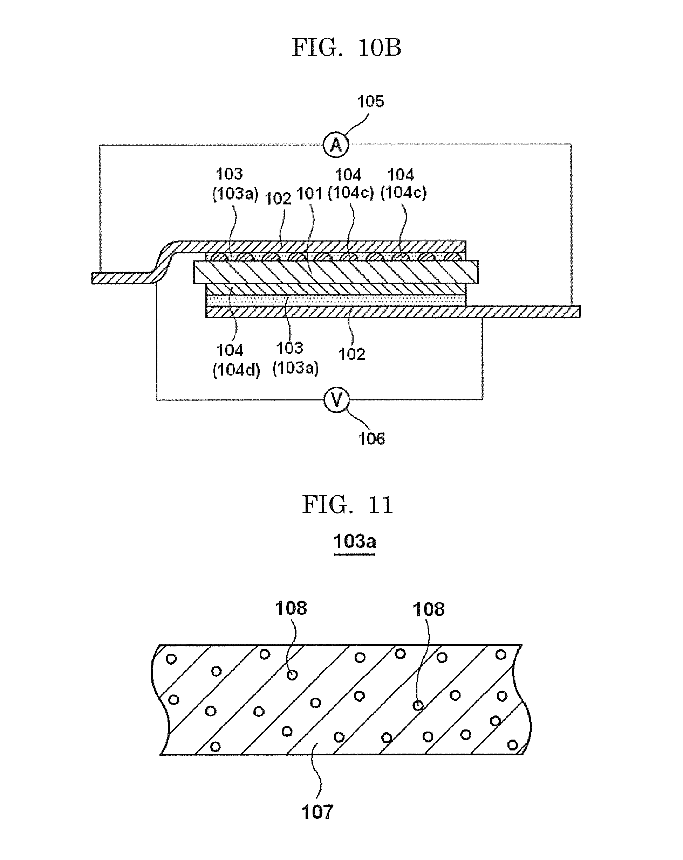

In the method for measuring output of a solar cell according to the present invention, as illustrated in FIGs. 9A, 9B, 10A, and 10B, a measuring terminal piece 102 formed of a ribbon-formed metal foil, which has a length equal to or greater than a length of an electrode 104 that is formed over a space between two sides of a solar cell 101 facing to each other, is arranged, as a measuring device, on a surface of the electrode of the solar cell 101, via an adhesive 103.

Specifically, this measuring terminal piece 102 is formed of a long film electrically conductive base having a length equal to or greater than a length of the electrode 104 formed over a space between two sides of the rectangle-shaped solar cell 101 facing to each other. For example, a 9 µm to 300 µm-thick ribbon formed copper foil having the same width to that of the below-mentioned electrically conductive adhesive film 103a is used, and the copper foil is optionally gold-plated, silver-plated, tin-plated, or solder-plated.

As illustrated in FIG. 9A and 9B, for example, the measuring terminal pieces 102 are respectively arranged on a p-type electrode 104a and an n-type electrode 104b formed on a surface of a thin film solar cell 101, and an ampere meter 105, or a voltmeter 106, or both are connected between the measuring terminal pieces 102 each provided on the surface electrode. In this output measuring method, moreover, electric current passing through the solar cell 101 via the measuring terminal pieces 102, or the voltage generated in the solar cell 101, or both are measured by applying the predetermined simulated sun light.

As illustrated in FIGs. 10A and 10B, for example, the measuring terminal piece 102 is provided on a rear face electrode 104d formed on the entire rear face, as well as being arranged to be perpendicular to a plurality of finger electrodes 104c formed on a surface of the crystal silicon solar cell 101. An ampere meter 105, or a voltmeter 106, or both are connected between the measuring terminal pieces 102 provided the surface and rear face of the crystal silicon solar cell 101, respectively. In this output measuring method, moreover, electric current passing through the solar cell 101 via the measuring terminal pieces 102, or the voltage generated in the solar cell 101, or both are measured by applying the predetermined simulated sun light.

The measuring terminal piece 102 can be arranged on the electrode 104 of the solar cell 101 via an adhesive 103. As for the adhesive 103, for example, the electrically conductive adhesive film 103a can be used. As illustrated in FIG. 9A, the electrically conductive adhesive film 103a may be laminated on a surface of the measuring terminal piece 102 to be integrated in advance. Alternatively, the electrically conductive adhesive film 103a may be arranged on a surface of an electrode of the solar cell 101, followed by superimposing and arranging the measuring terminal piece 102 thereon at the time of the measurement.

As illustrated in FIG. 11, the electrically conductive adhesive film 103a contains electrically conductive filler 108 in a binder resin 107 at a high density, and is formed into a film. For example, SP100 series, manufactured by Dexerials Corporation, can be used as the electrically conductive adhesive film 103a.

The electrically conductive filler 108 for use in the electrically conductive adhesive film 103a is not particularly limited, and examples thereof include: metal particles, such as nickel, gold, silver, and copper; gold-plated resin particles; and gold-plated resin particles to outermost layers of which is provided with an insulating coat.

A composition of the binder resin 107 of the electrically conductive adhesive film 103a is not particularly limited. For example, a heat-curing epoxy curable resin composition, or an acryl curable resin composition can be used.

The epoxy curable resin composition is, for example, composed of a compound or resin containing two or more epoxy groups in a molecule thereof, an epoxy curing agent, and a film forming component.

The compound or resin containing two or more epoxy groups in a molecule thereof may be liquid or a solid, and examples thereof include: bifunctional epoxy resin, such as a bisphenol A epoxy resin, and a bisphenol F epoxy resin; and a novolak epoxy resin, such as a phenol novolak epoxy resin, and cresol novolak epoxy resin. Moreover, an alicyclic epoxy compound, such as 3,4-epoxycyclohexenylmethyl-3',4'-epoxycyclohexene carboxylate, can also be used.

Examples of the epoxy curing agent include an amine curing agent, an imidazole curing agent, an acid anhydride curing agent, and a sulfonium cation curing agent. The epoxy curing agent may be a latent curing agent.

Examples of the film forming component include an epoxy compound, a phenoxy resin compatible to an epoxy resin, and an acryl resin compatible to an epoxy resin.

The epoxy curable resin composition may contain a conventional curing accelerator, a silane coupling agent, a metal trapping agent, a stress relaxant (e.g., butadiene rubber), inorganic filler (e.g., silica), a polyisocyanate curing agent, a colorant, an antiseptic agent, and a solvent, according to the necessity.

The acryl curable resin composition is, for example, composed of a (meth)acrylate monomer, a film forming resin, inorganic filler (e.g., silica), a silane coupling agent, and a radical polymerization initiator.

As for the (meth)acrylate monomer, for example, a monofunctional (meth)acrylate monomer, a polyfunctional (meth)acrylate monomer, and a modified monofunctional or polyfunctional (meth)acrylate monomer to which an epoxy group, a urethane group, an amino group, an ethylene oxide group, or a propylene oxide group is introduced, can be used. Moreover, another monomer radically copolymerizable with the (meth)acrylate monomer, such as (meth)acrylic acid, vinyl acetate, styrene, and vinyl chloride, can be used in combination, as long as the obtainable effect of the present invention is not adversely affected.

Examples of the film forming resin used in the acryl curable resin composition include a phenoxy resin, a polyvinyl acetal resin, a polyvinyl butyral resin, an alkylated cellulose resin, a polyester resin, an acrylic resin, a styrene resin, a urethane resin, and a polyethylene terephthalate resin.

Examples of the radical polymerization initiator include: organic peroxide, such as benzoyl peroxide, dicumyl peroxide, and dibutyl peroxide; and an azobis-based compound, such as azobisisobutyronitrile, and azobisvaleronitrile.

The acryl curable resin composition optionally contains a stress relaxant, such as butadiene rubber, a solvent, such as ethyl acetate, a colorant, an antioxidant, and an age resister.

The formation of the electrically conductive adhesive film from the binder resin 107 composed of an epoxy curable resin composition or acryl curable resin composition containing the electrically conductive filler 108 can be carried out by a conventional method. For example, the electrically conductive filler 108, a film forming resin, a liquid epoxy resin, a latent curing agent, and a silane coupling agent are dissolved in a solvent to obtain a resin generating solution. The resin generating solution obtained by dissolving is applied on the release sheet 109, and the solvent is evaporated, to thereby obtain an electrically conductive adhesive film 103a formed into a film. As for the solvent, for example, toluene, ethyl acetate, or a mixed solvent thereof can be used.

The release sheet 109 is not particularly limited. For example, polyethylene terephthalate (PET), oriented polypropylene (OPP), poly-4-methylpentene-1 (PMP), or polytetrafluoroethylene (PTFE) can be used. The film-formed electrically conductive adhesive film 103a is wound around a reel.

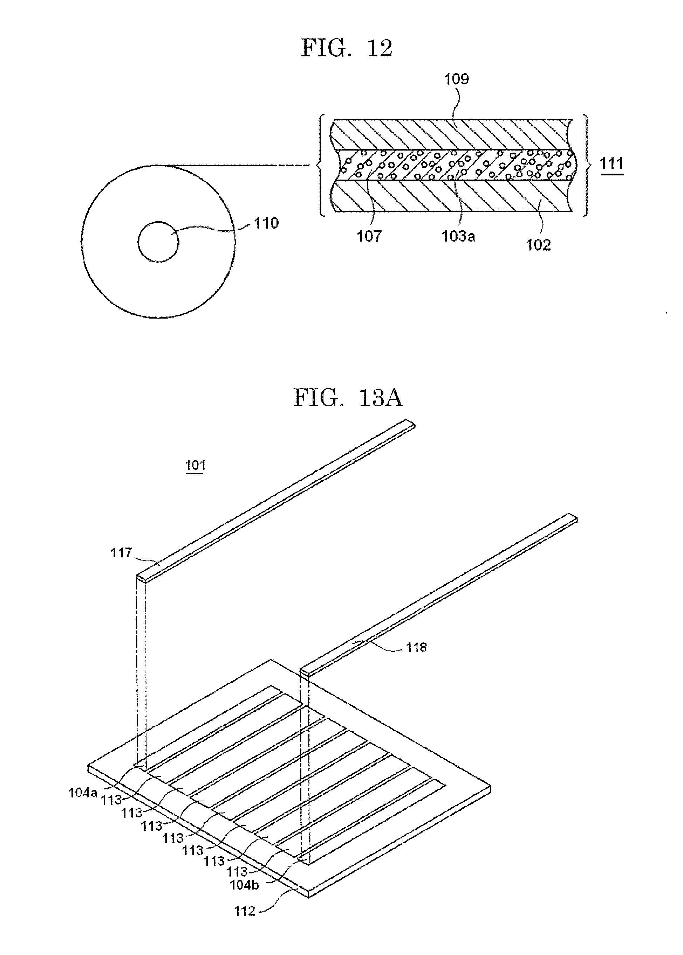

In the case where the measuring terminal piece 102 and the electrically conductive adhesive film 103a are laminated and integrated in advance, the measuring terminal piece 102 and the electrically conductive adhesive film 103a both wound around respective reels are both pulled out, and are bonded together by a roller laminator. As illustrated in FIG. 12, the laminate 111 containing the measuring terminal piece 102 and the electrically conductive adhesive film 103a are wound around the 110 and stored, and is pulled out at the time of use.

At the time of a measurement of output of the solar cell 101, the laminate 111 containing the measuring terminal piece 102 and the electrically conductive adhesive film 103a is cut to the length that is equal to or greater than a length between two sides of the solar cell 101 facing to each other, and is temporarily bonded onto the electrode 104 formed on a surface of the solar cell 101 over a space between the two facing sides thereof.

During this process, the laminates 111 are respectively arranged on a p-type electrode 104a and n-type electrode 104b provided on a surface of a thin film solar cell 101 (FIGs. 9A and 9B). As well as arranging the laminate 111 to be perpendicular to finger electrodes 104c formed on a surface of a silicon solar cell 101, the laminate is arranged on a rear face electrode 104d formed on the entire rear face (FIGs. 10A and 10B).

Thereafter, the electrically conductive adhesive film 103a is pressed from the side of the measuring terminal piece 102 by a bonder for the predetermined period at the predetermined pressure, to thereby connect the measuring terminal pieces 102 with the electrodes 104a to 104d directly or via the electrically conductive filler 108 by the tacking force of the binder resin 107. As a result, the electrically conductive adhesive film 103a can realize conduction connection, as well as bonding the measuring terminal pieces 102 onto the electrodes 104a to 104d.

Note that, in the case where the measuring terminal piece 102 and the electrically conductive adhesive film 103a are separately arranged on the solar cell 101, first, the electrically conductive adhesive films 103a, each of which has been cut to the predetermined length, are temporarily bonded so that the electrically conductive adhesive films 103a are superimposed on the electrodes 104a to 104d of the solar cell 101 in the length direction over a space between two sides thereof facing to each other. Subsequently, the measuring terminal pieces 102, each of which has been cut to the predetermined length, are arranged and superimposed on the electrically conductive adhesive films 103a, and thereafter, they are pressed from the top of the measuring terminal pieces 102 by a bonder.

An ampere meter 105, a voltmeter 106, or both are connected between the measuring terminal pieces 102 respectively connected to the electrodes 104a and 104b, or the electrodes 104c and 104d, and they are provided for a measurement of output of the solar cell 101. As the measuring terminal piece 102 uses a ribbon-formed metal foil, such as a copper foil, as a base, and is connected via the adhesive 103, the measuring terminal piece 102 can be uniformly adhered to all of the electrodes 104a to 104d. As the measuring terminal piece 102 does not create a shadow on a light-accepting surface of the solar cell 101, moreover, a measurement error due to a shadow loss is not caused. As the measuring terminal piece 102 is a metal foil to be adhered, a load, which is applied when a dedicated measuring device is used, is not applied to the solar cell 101.

After the measurement of output, the measuring terminal piece 102 and the adhesive 103 are removed from the electrodes 104a to 104d of the solar cell. As the laminate 111 containing the measuring terminal piece 102 and the electrically conductive adhesive film 103a is used, the measuring terminal piece 102 and the adhesive 103 are removed at the same time.

The tacking force of the electrically conductive adhesive film 103a for temporarily bonding to the electrodes 104a to 104d of the solar cell 101, or releasing ability thereof for removing the measuring terminal piece 102 from the electrodes 104a to 104d of the solar cell 101 after the output measurement can be adjusted by adjusting a blended ratio of the binder resin composition, or an amount of the electrically conductive filler 108 contained in the binder resin 107.

Note that, in the case where a silicon solar cell is used as the solar cell 101, for example, the measuring terminal piece 102 and the adhesive 103 are arranged so that they superimpose on a bus bar electrode formed on a surface of the solar cell 101 over a space between two sides thereof facing to each other. In the case where a bus bar-less silicon solar cell, in which a bus bar electrode is not formed, and only finger electrodes are included, the measuring terminal piece 102 and the adhesive 103 are arranged over a space between two sizes of the solar cell facing to each other so that the measuring terminal piece 102 and the adhesive 103 are perpendicular to all the finger electrodes. As the measuring terminal piece 102 can be connected to all the finger electrodes with provided to be perpendicular to all of the finger electrodes, regardless of a formation interval of the finger electrodes 104c, an accurate measurement of output of the solar cell 101 can be performed. In the case where a solar cell of another embodiment is used, the measuring terminal piece 102 and the adhesive 103 are appropriately provided on an electrode that is an outlet of electrode.

Moreover, an example where the electrically conductive adhesive film 103a is used is explained above. In the present invention, however, not only a film-shaped electrically conductive adhesive, but also a paste electrically conductive adhesive, or an insulating adhesive, such as an insulating adhesive film and insulating adhesive paste, both of which does not contain electrically conductive particles, can also be used.

### [Solar Cell]

Subsequently, a solar cell 101, on which a measurement of electrical characteristics is performed with the measuring terminal piece 102, is explained. As for the solar cell 101, for example, a so-called thin film solar cell, in which a semiconductor layer that is a photoelectric conversion layer is formed on a substrate, such as glass, and stainless steel, can be used. The solar cell 101 that is a thin film solar cell is a super straight-type solar cell, in which a transparent electrode film, a photoelectric conversion layer, and a rear face electrode film are formed and laminated in this order on a translucent insulating substrate 112, though they are omitted in the drawings, and to which light enters from the side of the translucent insulating substrate 112. Note that, as for the thin film solar cell, there is also a substraight-type solar cell, in which a base, a rear face electrode, a photoelectric conversion layer, and a transparent electrode are formed in this order. An example of the super straight-type thin film solar cell 101 is explained hereinafter, but the present invention can be also used for a substraight-type thin film solar cell.

As for the solar cell 101 to which the present invention is applied. Moreover, a general thin film solar cell (for example, various thin film solar cells, such as amorphous silicon thin film solar cell, a microcrystal tandem thin film solar cell, a CdTe thin film solar cell, a CIS thin film solar cell, and a flexible thin film solar cell),or a crystal solar cell can be used.

As for the translucent insulating substrate 112, glass, or a heat resistant resin, such as polyimide, can be used.

As for the transparent electrode film, for example, SnO₂, ZnO, ITO, IZO, or AZO (transparent electrode body in which zinc oxide is doped with Al) can be used.

As for the photoelectric conversion layer, for example, a silicon-based photoelectric conversion film, such as amorphous silicon, microcrystal silicon, and polycrystal silicon, or a compound-based photoelectric conversion film, such as CdTe, CuInSe₂, and Cu(In,Ga)Se₂ can be used.

The rear face electrode film has a laminate structure containing a transparent electrically conductive film and a metal film. As for the transparent electrode film, for example, SnO₂, ZnO, ITO, IZO, or AZO can be used. As for the metal film, for example, silver or aluminum can be used.

In the solar cell 101 composed in the aforementioned manner, as illustrated in FIG. 9A, a plurality of rectangular solar cell elements 113 each having a length substantially equal to the entire width of the translucent insulating substrate 112. Each solar cell element 113 is divided with an electrode dividing line, and a transparent electrode film of one solar cell element 113 and a rear face electrode film of another adjacent solar cell element 113 are connected with a contact line, to thereby constitute a solar cell string, in which a plurality of solar cell elements 113 are connected in series.

In the solar cell 101, a linear p-type electrode 104a, which has the substantially same length to that of the solar cell element 113, is formed on an edge of a transparent electrode film of a solar cell element 113, which is provided at one end of the solar cell string, and a linear n-type electrode 104b, which has the substantially same length to that of the solar cell element 113, is formed on an edge of a rear face electrode film of a solar cell element 113, which is provided at the other end of the solar cell string. In the solar cell 101, these p-type electrode 104a and n-type electrode 104b serve as outlets of the electrodes, and supply electricity to the terminal box 119 via the tab wire for a positive electrode 117 and the tab wire for negative electrode 118.

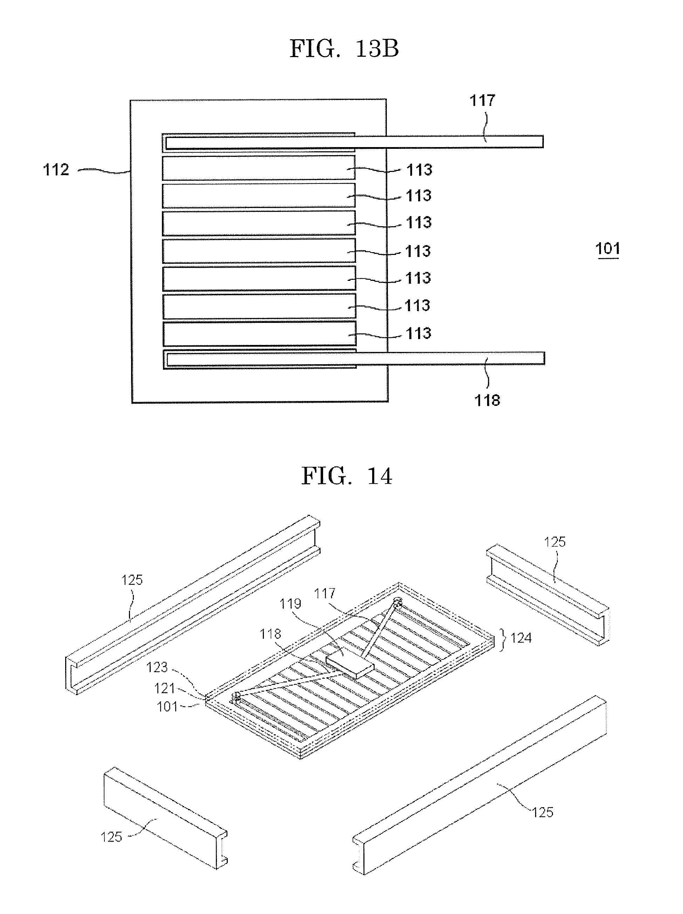

In the solar cell 101, as illustrated in FIGs. 13A and 13B, tab wire for a positive electrode 117 and tab wire for a negative electrode 118 are respectively connected on the p-type electrode 104a and the n-type electrode 104b via an adhesive layer. As for the adhesive layer, for example, solder, an electrically conductive adhesive film, or an electrically conductive adhesive paste can be used. The electrically conductive adhesive films may be superimposed on the tab wire for a positive electrode 117 and the tab wire for a negative electrode 118, respectively, after the electrically conductive adhesive films are temporarily bonded onto the p-type electrode 104a and the n-type electrode 104b, respectively. Alternatively, laminates, in each of which an electrically conductive adhesive film is laminated on a surface of the tab wire for a positive electrode 117 or tab wire for a negative electrode 118 in advance, may be provided on the p-type electrode 104a and the n-type electrode 104b, respectively.

As for the electrically conductive adhesive film, the one having the same structure to that of the aforementioned electrically conductive adhesive film 103a can be used. As for the tab wire for a positive electrode 117 and the tab wire for a negative electrode 118, those having the same structure to that of the aforementioned measuring terminal piece 102 can be used.

As illustrated in FIG. 14, the solar cell 101, to which the tab wire for a positive electrode 117 and tab wire for a negative electrode 118 have been temporarily bonded, alone, or a matrix constituted by linking a plurality thereof are collectively joined with a sheet 121 of a sealing adhesive and a back sheet 123 provided at the rear face side, through vacuum lamination. During the lamination, the solar cell 101 is heated by a heater so that the binder resin 107 of the electrically conductive adhesive film is heat cured to connect the tab wire for a positive electrode 117 and the tab wire for a negative electrode 118 on the p-type electrode 104a and the n-type electrode 104b, respectively, to thereby form a solar battery module 124. Note that, a metal frame 125, such as aluminum, is appropriately provided to the periphery of the solar battery module 124.

As for the sealing adhesive, for example, a translucent sealing material, such as an ethylene vinyl acetate resin (EVA) is used. As for the back sheet 123, moreover, a plastic film or sheet having excellent properties, such as weather resistance, thermal resistance, water resistance, and light fastness, is used. As for the back sheet 123, for example, a laminate sheet having a structure of polyvinyl fluoride (PVF)/polyethylene terephthalate (PET)/polyvinyl fluoride (PVF), which utilizes characteristics of a fluorine-based resin, such as high resistance, can be used.

After connecting the tab wire for a positive electrode 117 and the tab wire for a negative electrode 118 on the p-type electrode 104a and the n-type electrode 104b, respectively, a portion of the tab wire extended from the bonded portion is turned, and pierced through insertion holes provided the sheet 121 of a sealing material and the back sheet 123, and then is connected to a terminal box 119 provided on the back sheet 123.

In case of a crystal silicon solar cell 101, as illustrated in FIG. 15, a plurality of linear finger electrodes 130 configured to collect electricity generated within a light-accepting surface is provided, for example, by applying an Ag paste through screen printing, followed by baking. As the finger electrodes 130, for example, a plurality of lines each having a width of about 50 µm to about 200 µm is substantially parallelly formed at the predetermined interval, such as 2 mm. As for the solar cell 101, a solar cell of a so-called bus bar-less structure, in which a bus bar electrode to which tab wire 131 is imposed, can be used. In this case, in the solar cell 101, the tab wire 131 is directly connected to the finger electrodes 130 via the electrically conductive adhesive film 103a. Note that, in the case where a bus bar electrode perpendicular to the finger electrodes 130 is provided, in the solar cell 101, the tab wire 131 is connected to the bus bar electrode via the electrically conductive adhesive film 103a so that the tab wire 131 is superimposed on the bus bar electrode. As for the tab wire 131, moreover, the one identical to the aforementioned measuring terminal piece 102 can be used.

Moreover, a rear face electrode 132 formed of aluminum, or silver is provided at the rear face side of the solar cell 101, which is an opposite side to a light-accepting surface. The rear face electrode 132 is, for example, an electrode formed of aluminum, or silver, formed by screen printing, or sputtering. The tab wire 131 is also connected to the rear face electrode 132 via the electrically conductive adhesive film 103a.

As illustrated in FIG. 15, crystal silicon solar cells 101 form a string 133, by connecting finger electrodes 130 formed on a surface of a solar cell 101 to a rear face electrode 132 formed on a rear face of an adjacent solar cell 101 with the tab wire 131. Sheets 121 of a translucent sealing material, such as EVA, are provided on a surface and rear face of the string 133, and are laminated together with a surface cover and a back sheet by a vacuum laminator. During the lamination, the electrically conductive adhesive film 103a is heated for the predetermined period at the predetermined temperature, to thereby connect the tab wire 131 with the finger electrodes 130 and the rat face electrode 132. As a result, a crystal silicon solar battery module is formed. Finally, a metal frame 125, such as aluminum, is provided at the periphery of the crystal silicon solar battery module.

### Examples

### (Example 1)

Subsequently, Example of the method for measuring output of a solar cell according to the present invention is explained. In Example 1, as for a measuring terminal piece 102 and an adhesive 103, a laminate 111 containing a ribbon-formed copper foil and an electrically conductive adhesive film 103a was used, and the laminate 111 was bonded onto a p-type electrode and n-type electrode of a thin film solar cell so that the laminate was perpendicular to all the finger electrodes of a crystal silicon solar cell. A measurement of output characteristics of each solar cell was performed, and after the measurement, the laminate 111 was removed, and whether or not the tab wire was soldered was judged.

The measurement of the output characteristics of a solar cell was performed by connecting a solar simulator (PVS1116i, manufactured by Nisshinbo Mechatronics Inc.) between the measuring terminal pieces 102.

The binder resin composition of the electrically conductive adhesive film 103a was as follows:
Phenoxy resin (YP50, manufactured by NIPPON STEEL & SUMIKIN CHEMICAL CO., LTD.) 50 parts by mass
Epoxy resin (Epicoat 630, manufactured by Mitsubishi Chemical Corporation) 4 parts by mass
Liquid epoxy dispersed imidazole curing agent resin (Novacure 3941HP,
manufactured by Asahi Kasei E-materials Corporation) 25 parts by mass
Silane coupling agent (A-187, manufactured by Momentive Performance Materials Inc.) 1 part by mass

In Example 1, a thin film solar cell was used, and measuring terminal pieces 102 were bonded to a p-type electrode and an n-type electrode, respectively. Moreover, the electrically conductive adhesive film 103a contained 5 parts by mass of nickel particles (F255, manufactured by Vale Inco) as the electrically conductive filler, and the tacking force thereof was 0.3 N. The surface roughness (Rz) of a surface of the measuring terminal piece 102 onto which the electrically conductive adhesive film 103a was laminated was 10 µm.

### (Example 2)

The same conditions to those of Example 1 were applied, provided that an amount of the nickel particles contained in the electrically conductive adhesive film 103a was changed to 20 parts by mass in Example 2.

### (Example 3)

The same conditions to those of Example 1 were applied, provided that an amount of the nickel particles contained in the electrically conductive adhesive film 103a was changed to 40 parts by mass in Example 3.

### (Example 4)

The same conditions to those of Example 1 were applied, provided that an amount of the nickel particles contained in the electrically conductive adhesive film 103a was changed to 60 parts by mass in Example 4.

### (Example 5)

The same conditions to those of Example 2 were applied, provided that the measuring terminal pieces 102 were respectively bonded onto a p-type electrode and an n-type electrode, both of which were formed of an AZO film.

### (Example 6)

The same conditions to those of Example 2 were applied, provided that a p-type electrode and an n-type electrode were each formed by applying an Ag paste and baking the paste.

### (Example 7)

The same conditions to those of Example 2 were applied, provided that the tacking force was adjusted to 0.1 N by forming the electrically conductive adhesive film thin.

### (Example 8)

The same conditions to those of Example 2 were applied, provided that the tacking force was adjusted to 5 N by forming the electrically conductive adhesive film thick.

### (Example 9)

The same conditions to those of Example 2 were applied, provided that gold-plated resin particles (Micropearl AU, manufactured by Sekisui Chemical Co., Ltd.) were used as the electrically conductive filler.

### (Example 10)

The same conditions to those of Example 2 were applied, provided that copper particles (MA-C04J, manufactured by MITSUI MINING & SMELTING CO., LTD.) were used as the electrically conductive filler.

### (Example 11)

In Example 11, a crystal silicon solar cell was used as a solar cell. An paste was applied between two sides of this solar cell facing to each other on a surface that was to be a light-accepting surface by screen printing, followed by baking to thereby form finger electrodes and bus bar electrodes. As for the finger electrodes, a plurality of thin lines was parallelly formed with a predetermined interval of 2 mm over the entire light-accepting surface. As for the bus bar electrodes, two lines each having a substantially same width to that of the measuring terminal piece were formed to be perpendicular to all of the finger electrodes. The measuring terminal pieces 102 were respectively provided on the bus bar electrodes via the electrically conductive adhesive film 103a between two sides of the solar cell facing to each other. Other conditions were the same as in Example 2.

### (Example 12)

In Example 12, used was a bus bar-less solar cell, which was formed by forming an SiN film as an anti-reflection film on a silicon substrate through plasma CVD, and forming only finger electrodes through application and baking of the Ag paste in the same manner as in Example 11, without forming bus bar electrodes. The measuring terminal pieces were provided via the electrically conductive adhesive film 103a to be perpendicular to all of the finger electrodes between two sides of the solar cell facing to each other. Other conditions were the same as in Example 2.

### (Example 13)

The same conditions to those of Example 2 were applied, provided that, as for the measuring terminal piece 102, a ribbon-formed copper foil whose surface where the electrically conductive adhesive film 103a was laminated had a surface roughness (Rz) of 5 µm was used.

### (Example 14)

The same conditions to those of Example 2 were applied, provided that, as for the measuring terminal piece 102, a ribbon-formed copper foil whose surface where the electrically conductive adhesive film 103a was laminated had a surface roughness (Rz) of 20 µm was used.

### (Comparative Example 1)

In Comparative Example 1, a measurement of output characteristics was performed by using a conventional probe pin for measuring electric current and probe pin for measuring voltage (see FIGs. 16 and 17) as measuring devices, and bringing these probe pins into contact with the p-type electrode and n-type electrode of the thin film solar cell, both formed of an ITO film.

### (Comparative Example 2)

In Comparative Example 2, a measurement of output characteristics was performed by using a laminate containing an electrically conductive highly adhesive tape tacking force of which was enhanced to 500 N by adjusting the binder composition, and a measuring terminal piece 102, as a measuring device, and bonding the laminates onto a p-type electrode and an n-type electrode, both formed of an AZO film.

In each of Examples and Comparative Examples, a measurement of output characteristics of the solar cell was performed by means of a solar simulator (Solar Simulator PVS1116i-M, manufactured by Nisshinbo Mechatronics Inc.) under typical measurement conditions (illuminance: 1,000 W/m², temperature: 25°C, spectrum: AM1.5G). Moreover, the measurement was performed by so-called four-terminal sensing in accordance with JIS C8913 (crystal solar cell element output measuring method).

As for the evaluation, the solar cell on which the measurement of output characteristics (EL measurement) could be performed was determined as I, the solar cell on which the EL measurement could not be performed was determined as II. Moreover, a case where the measured value of the output characteristics was 99% or greater of the output value as the dedicated device was determined as A, a case where the measured value was 90% or greater but less than 99% was determined as B, and a case where the measured value was less than 90% was determined as C.

A measurement of the tacking force was performed by means of a probe tack tester (manufactured by Rhesca Corporation). The diameter of the probe was 5 mm, the test speed was 120 mm/min, the pressing time was 1.0 sec, and the pressing distance was 2.0 mm.

The surface roughness (Rz) was measured by means of a laser microscope (LSM5 PASCAL, manufactured by Zeiss).

Moreover, the measuring terminal piece 102 was removed after the measurements, and whether or not a residue of the electrically conductive adhesive film 103a was remained was visually observed and evaluated. Furthermore, whether or not a treatment for washing out the residues was necessary when soldering was performed on the electrode after removing the measuring terminal piece 102 was evaluated. A case where the residues of the electrically conductive adhesive film 103a were remained at less than 3% per unit area was determined as A, a case where the residues were remained at 3% or greater but less than 10% was determined as B, and a case where the residues were remained at 10% or greater or a case where the electrode was also removed together with the measuring terminal piece 102 was determined as C. Moreover, a case where soldering connection was performed without a washing treatment after removing the measuring terminal piece 102 was determined as I, and a case where a washing treatment was necessary was determined as II.

Moreover, a margin of a setting position of the measuring terminal piece 102 or the measuring device, and whether or not it easily corresponded to a change in the size of the substrate of the solar cell were evaluated. A case where the measuring terminal piece 102 or the measuring device could be mounted in an arbitrary location was determined as I, and a case where the measuring terminal piece 102 or the measuring device could be only mounted in the specified location was determined as II. Moreover, a case where it could correspond to a change of the size of the solar cell without any condition was determined as A, a case where it could correspond only under the certain conditions was determined as B, and a case where it could not correspond was determined as C.

Furthermore, a damage on the electrode after removing the measuring terminal piece 102 or the measuring device was visually observed and evaluated. A case where there was no damage on the electrode was evaluated as A, a case where there was a damage on a part of the electrode was determined as B, and a case where the electrode was destroyed was determined as C. These results are presented in Tables 1 and 2.

**Table 1**

| | Ex. 1 | Ex. 2 | Ex. 3 | Ex. 4 | Ex.5 | Ex.6 | Ex. 7 | Ex.8 | Ex. 9 |
|---|---|---|---|---|---|---|---|---|---|
| Measuring device | Copper foil/ adhesive film laminate | Copper foil/ adhesive film laminate | Copper foil/ adhesive film laminate | Copper foil/ adhesive film laminate | Copper foil/ adhesive film laminate | Copper foil/ adhesive film laminate | Copper foil/ adhesive film laminate | Copper foil/ adhesive film laminate | Copper foil/ adhesive film laminate |
| Solar cell | Thin film | Thin film | Thin film | Thin film | Thin film | Thin film | Thin film | Thin film | Thin film |
| Electrode (bonding target) | ITO | ITO | ITO | ITO | ITO | Baked Ag | ITO | ITO | ITO |
| Tacking force (N) | 0.3 | 0.3 | 0.3 | 0.3 | 0.3 | 0.3 | 0.1 | 5 | 0.3 |
| Conductive filler | Nickel | Nickel | Nickel | Nickel | Nickel | Nickel | Nickel | Nickel | Gold-plated resin |
| Amount of conductive filler | 5 | 20 | 40 | 60 | 20 | 20 | 20 | 20 | 20 |
| Rzofone surface of measuring terminal (µm) | 10 | 10 | 10 | 10 | 10 | 10 | 10 | 10 | 10 |
| EL measurement | I | I | I | I | I | I | I | I | I |
| Output | C | A | A | C | A | A | C | A | B |
| Residues amount after removing measuring terminal | B | B | A | A | B | B | A | B | A |
| Soldering after removing measuring terminal | I | I | I | I | I | I | I | I | I |
| Setting position | I | I | I | I | I | I | I | I | I |
| Corresponding to size change of solar cell | A | A | A | A | A | A | A | A | A |
| Electrode damage | B | A | A | A | A | A | A | B | A |

**Table 2**

| | Ex. 10 | Ex. 11 | Ex. 12 | Ex. 13 | Ex. 14 | Comp. Ex. 1 | Comp. Ex. 2 |
|---|---|---|---|---|---|---|---|
| Measuring device | Copper foil/ adhesive film laminate | Copper foil/ adhesive film laminate | Copper foil/ adhesive film laminate | Copper foil/ adhesive film laminate | Copper foil/ adhesive film laminate | None (dedicated device) | Highly adhesive tape |
| Solar cell | Thin film | Crystal | Crystal | Thin film | Thin film | Thin film | Thin film |
| Electrode (bonding target) | ITO | Baked Ag | Baked Ag/SiN | ITO | ITO | ITO | AZO |
| Tacking force (N) | 0.3 | 0.3 | 0.3 | 0.3 | 0.3 | - | 500 |
| Conductive filler | Copper | Nickel | Nickel | Nickel | Nickel | - | Nickel |
| Amount of conductive filler | 20 | 20 | 20 | 20 | 20 | - | 20 |
| Rzofone surface of measuring terminal (µm) | 10 | 10 | 10 | 5 | 20 | - | 10 |
| EL measurement | I | I | I | I | I | I | I |
| Output | B | B | B | B | B | A | A |
| Residues amount after removing Measuring terminal | B | B | B | B | A | - | C |
| Soldering after removing measuring terminal | I | I | - | I | I | I | II |
| Setting position | I | I | I | I | I | II | I |
| Corresponding to size change of solar cell | A | A | A | A | A | C | A |
| Electrode damage | A | A | A | A | A | C | C |

In Tables 1 and 2, the conductive filler (electrically conductive filler) amount is a value (parts by mass) relative to 80 parts by mass of the binder resin.

As depicted in Tables 1 and 2, each Example using the measuring terminal piece, a measurement of output, which was not inferior to a measurement performed using a dedicated measuring device, can be performed both on a thin film solar cell and a crystal silicon solar cell. In each Example, moreover, residues of the adhesive were hardly observed after removing the measuring terminal piece 102, and the soldering of the tab wire was performed without a washing treatment. As the measuring terminal piece using a metal foil was bonded in each Example, the measuring terminal piece could be freely connected to a surface of the solar cell, and could be easily corresponded to a change in a size of the solar cell. In each Example, moreover, any significant damage was not observed after removing the measuring terminal piece.

As a conventional dedicated measuring device using a probe pin (see FIG. 17) was used in Comparative Example 1, connection positions to the surface electrodes were defined with an interval for providing probe pins, and therefore connection corresponding the positions of the electrodes was not possible. As the size of the measuring terminal was already specified, moreover, a size of the measuring terminal could not be changed corresponding to an increased cell size of the solar cell. Moreover, there are variations in height between the probe pins or electrodes, and therefore part of the electrodes were destroyed by pressing the device to the solar cell at the predetermined pressure to bring the probe pins into contact with all the electrodes. In Comparative Example 1, moreover, there was a shadow loss in the measured value due to an influence of a shadow created by the dedicated measuring device on the light-accepting surface, and therefore it was difficult to accurately measure output characteristics.

As the measuring terminal piece 102 was adhered using a highly adhesive tape having a tacking force of 500 N in Comparative Example 2, the residues of the binder resin were remained on the surface electrode at 10% or greater per unit area when the measuring terminal piece 102 was removed after the measurement. Therefore, the tab wire could not be connected by soldering unless a washing treatment was performed. Moreover, the electrode was destroyed when the measuring terminal piece 102 was removed.

Looking at Examples 1 to 4, where an amount of the electrically conductive filler was changed, the output value of Example 1, in which the amount of the electrically conductive filler was small, i.e., 5 parts by mass, was less than 90% of the value when a dedicated measuring device was used. It is assumed that it is because the amount of the electrically conductive filler is slightly smaller, compared to Examples 2 and 3. In Example 4 where the amount of the electrically conductive filler was large, i.e., 60 parts by mass, similarly, the output value was less than 90% of the value when a dedicated measuring device was used. It is assumed that it is because an amount of the electrically conductive filler is excessive relative to the binder resin, the connection between the measuring terminal piece 102 and the surface electrode becomes poor. Considering the above, the amount of the electrically conductive filler in the electrically conductive adhesive film 103a is preferably 20 parts by mass to 40 parts by mass relative to 80 parts by mass of the binder resin composition.

From Examples 5 and 6, in which a type of the electrode film for use was changed, it was found out that the measurement of output characteristics using the measuring terminal piece 102 was possible regardless of a type of the electrode film.

Looking at Examples 7 and 8 where the tacking force was changed, in Example 7, in which the tacking force was 0. 1 N, the output value was less than 90% of the value when the dedicated measuring device was used. It is assumed that it is because the tacking force is small compared to other Examples, and therefore the connection between the measuring terminal piece 102 and the surface electrode becomes poor. In Example 8 where the tacking force was 5 N, moreover, the residues of the electrically conductive adhesive film 103a were remained at 3% or greater but less than 10% per unit area after removing the measuring terminal piece 102. It is assumed that this is because the tacking force is large, and therefore the electrically conductive adhesive film cannot be completely removed when the measuring terminal piece 102 is removed. Considering the above, the taking force of the electrically conductive adhesive film 103a is preferably 0.1 N or greater but less than 5 N.

From Examples 9 and 10 where a type of the electrically conductive filler for use was changed, it was found that there was no difference in the output measurement depending on a type of the electrically conductive filler. In Example 9 where the gold-plated resin was used, the residues of the binder resin were hardly remained after removing the measuring terminal piece 102.

From Examples 11 and 12 where the silicon solar cell element was used, it was found that the output measurement using the measuring terminal piece 102 could be performed on both a silicon solar cell element with bus bar electrodes, and a bus bar-less type silicon solar cell element. Especially, in the bus bar-less type solar cell, the measuring terminal piece 102 can be uniformly connected to all the electrodes regardless of variations in the interval or height of the finger electrodes.

From Examples 13 and 14 where the surface roughness Rz (µm) of the measuring terminal piece 102 was changed, it was found that there was not a large difference in the output measurement depending on the surface roughness Rz of the measuring terminal piece 102. In Example 14 where the surface roughness Rz of the measuring terminal piece 102 was 20 µm, the residues of the binder resin were hardly remained after removing the measuring terminal piece 102.

### Reference Signs List

- 1: thin film solar cell
- 2: solar cell element
- 3: sheet
- 4: back sheet
- 5: surface cover
- 6: thin film solar battery module
- 7: metal frame
- 8: translucent insulating substrate
- 9: p-type electrode terminal part
- 10: n-type electrode terminal part
- 11: tab wire for a positive electrode
- 12: positive electrode power collection tab part
- 13: positive electrode connection tab part
- 14: turning part
- 15: tab wire for negative electrode
- 16: negative electrode power collection tab part
- 17: negative electrode connection tab part
- 19: terminal box
- 20: tab wire
- 21: adhesive layer
- 22: laminate
- 23: electrically conductive adhesive film
- 24: binder resin layer
- 25: electrically conductive particles
- 26: reel
- 27: release base
- 29: cable
- 30: silicon solar cell element
- 31: finger electrode
- 32: tab wire
- 33: adhesive layer
- 34: string
- 35: power collection tab part
- 36: connection tab part
- 37: rear face electrode
- 38: silicon solar battery module
- 50: probe pin for measuring electric current
- 51: probe pin for measuring voltage
- 53: solar cell
- 54: bus bar electrode
- 55: solar cell
- 56: probe pin
- 57: finger electrode
- 101: solar cell
- 102: measuring terminal piece
- 103: adhesive
- 103a: electrically conductive adhesive film
- 104: electrode
- 104a: p-type electrode
- 104b: n-type electrode
- 104c: finger electrode
- 104d: rear face electrode
- 105: ampere meter
- 106: voltmeter
- 107: binder resin
- 108: electrically conductive filler
- 109: release sheet
- 110: reel
- 111: laminate
- 112: translucent insulating substrate
- 113: solar cell element
- 115: p-type electrode terminal part
- 116: n-type electrode terminal part
- 117: tab wire for a positive electrode
- 118: tab wire for negative electrode
- 119: terminal box
- 121: sheet
- 123: back sheet
- 124: solar battery module
- 125: metal frame
- 130: finger electrode
- 131: tab wire
- 132: rear face electrode
- 133: string

## Claims

1. A method for producing a solar battery module, comprising:
arranging tab wire on an electrode of a solar cell via an adhesive;
connecting the tab wire with a measuring device for measuring electrical characteristics of the solar cell, to measure electrical characteristics of the solar cell;
judging a grade of the solar cell based on a result of the measurement; and
modularizing the solar cells of the same grade.

2. The method for producing a solar battery module according to claim 1, wherein the modularizing contains sealing the solar cells with a sealing material and a protective material, and connecting the tab wire piercing through the sealing material and the protective material with a terminal box.

3. The method for producing a solar battery module according to claim 1, wherein the modularizing contains aligning the solar cells of the same grade, and forming a string with the tab wire.

4. The method for producing a solar battery module according to any one of claims 1 to 3, wherein the arranging contains forming the adhesive into a film, and laminating the adhesive on a surface of the tab wire, which is brought into in contact with the solar cell.

5. The method for producing a solar battery module according to any one of claims 1, 2 and 4, wherein the solar cell is a thin film solar cell.

6. The method for producing a solar battery module according to any one of claims 1, 3 and 4, wherein the solar cell is a crystal silicon solar cell, and has a bus bar-less structure.

7. A method for measuring output of a solar cell, comprising:
arranging a measuring terminal piece formed of a ribbon-formed metal foil on an electrode of a solar cell via an adhesive; and
connecting an ampere meter or a volt meter, or both with the measuring terminal piece, to measure electrical characteristics of the solar cell.

8. The method for measuring output of a solar cell according to claim 7, wherein the measuring terminal piece has a length equal to or longer than a length of the electrode formed over a space between two sides of the solar cell facing to each other.

9. The method for measuring output of a solar cell according to claim 7 or 8, wherein the arranging contains forming the adhesive into a film, and laminating the adhesive on a surface of the measuring terminal piece, which is brought into in contact with the solar cell.

10. The method for measuring output of a solar cell according to any one of claims 7 to 9, wherein the adhesive is releasable from the solar cell after the connecting.

11. The method for measuring output of a solar cell according to any one of claims 7 to 10, wherein a tacking force of the adhesive is 0.1 N or greater but less than 5 N.

12. The method for measuring output of a solar cell according to any one of claims 7 to 11, wherein the adhesive is an electrically conductive adhesive, in which electrically conductive filler is dispersed in a binder resin.

13. The method for measuring output of a solar cell according to claim 12, wherein an amount of the electrically conductive filler in the adhesive is 5 parts by mass to 60 parts by mass, relative to 80 parts by mass of the binder resin.

14. The method for measuring output of a solar cell according to claim 12, wherein an amount of the electrically conductive filler in the adhesive is 20 parts by mass to 40 parts by mass, relative to 80 parts by mass of the binder resin.

15. The method for measuring output of a solar cell according to any one of claims 7 to 14, wherein a surface roughness (Rz) of the metal foil is 5 µm to 20 µm.

16. The method for measuring output of a solar cell according to any one of claims 7 to 15, wherein the solar cell is a crystal solar cell and has a bus bar-less structure.

17. The method for measuring output of a solar cell according to any one of claims 7 to 15, wherein the solar cell is a thin film solar cell.

18. A device for measuring output of a solar cell, comprising:
a measuring terminal piece, which is connected to an ampere meter or a voltmeter, or both and is formed of a ribbon-formed metal foil that is arranged on an electrode of a solar cell via an adhesive,
wherein the device is configured to measure electrical characteristics of the solar cell.

19. The device for measuring output of a solar cell according to claim 18, wherein the measuring terminal piece has a length equal to or greater than a length of the electrode formed over a space between two sides of the solar cell facing to each other.
